# EUROPEAN PATENT SPECIFICATION

(11) **EP 2 794 757 B1**
(45) Date of publication and mention of the grant of the patent: **15.05.2019**
(21) Application number: 12799483.8
(22) Date of filing: 04.12.2012
(51) Int. Cl.: C08L 63/00, C09D 5/24, H05K 7/20, H05K 5/00, C08L 71/02, C08L 53/00

(54) **PROCESS FOR PREPARING CURED EPOXY COMPOSITES**
VERFAHREN ZUR HERSTELLUNG AUSGEHÄRTETER EPOXIDVERBUNDWERKSTOFFE
PROCÉDÉ POUR PRÉPARER DES COMPOSITES DE RÉSINE ÉPOXYDE DURCIS

(30) Priority: 20.12.2011 US 201161577918 P
(43) Date of publication of application: 29.10.2014
(73) Proprietor: Dow Global Technologies LLC, Midland, MI 48674 (US); Rohm and Haas Electronic Materials LLC, Marlborough, MA 01752 (US)
(72) Inventor: FU, Lin, Naperville, IL 60563 (US); ESSEGHIR, Mohamed, Lawrenceville, NJ 08648 (US); HARRIS, William J., Lake Jackson, TX 77566 (US); BAYES, Martin W., Hopkinton, MA 01748 (US); EATON, Robert F., Belle Mead, NJ 08502 (US); KMIEC, Chester J., Phillipsburg, NJ 08865 (US); NEESE, Bret P., North Wales, PA 19454 (US)
(74) Representative: Beck Greener LLP
(86) International application number: PCT/US2012/067714
(87) International publication number: WO 2013/095908

(56) References cited:
- WO-A1-2009/018193
- WO-A1-2009/148525
- WO-A1-2010/102421

## Description

### FIELD

The present invention is related to a metalized epoxy resin composite and a process for preparing the metalized epoxy resin composite which may be useful in various applications, for example, in preparing cell tower communication equipment components such as radio frequency filters.

### BACKGROUND

It is expected that bandwidth demand will increase annually globally to support new services and increased number of users thus shifting wireless systems to higher frequency bands. There is a trend in the industry to move electronics from a base station to the top of the cell tower of such base station (that is, tower-top electronics). It is expensive to install and maintain antennas and radio remote heads on cell towers. Therefore, there is a need for light weight infrastructure of the cell tower and associated equipment.

A radio frequency (RF) filter is a key component in a remote radio head (RRH) device. RF filters are used to eliminate signals of certain frequencies. Such filters are commonly used as building blocks for duplexers and diplexers to combine or separate multiple frequency bands. RF filters play a key role in minimizing interference between systems operating in different bands.

A RF cavity filter is a commonly used RF filter. A common practice to make these filters of various designs and physical geometries is to die cast aluminum into the desired structure or machine a final geometry from a die cast pre-form. An example of RF filter is shown and described in U.S. Patent No. 7,847,658. It is known that the current die cast aluminum technology is energy intensive (for example, about 7500 BTU/cubic inches as disclosed in Reaction Injection Molding, Walter E. Becker, Ed., Van Nostrand-Reinhold, New York, 1979, 316 pp.). In addition, the aluminum density of the die cast aluminum filters is about 2.7 g/cc and part manufacturing requires time-consuming post machining due to the complex geometry of the cavity duplexer filter requiring die tooling with finite die lifetime and intensive labor.

Furthermore, due to the growing miniaturization and drive for reducing the weight of the top components of a cellular tower infrastructure and its subcomponents, it is also desired to make filters of lighter weight (today the weight of aluminum made filters, depending on the design, generally ranges from a few kg to as high as about 15 kg or more) while maintaining acceptable coefficient of thermal expansion (CTE) and performance close to that of incumbent material.

A first critical parameter for RF cavity filter performance is the cavity dimensional stability of the RF cavity filter in outdoor conditions (for example, from about - 50 °C to about 85 °C). A high CTE filter housing material is less desirable as compared to a low CTE filter housing material because with temperature fluctuations in the environment surrounding the filter body housing, the higher CTE material can have larger changes in the shape and size of the cavities in the body housing sufficient to alter the filtering frequency of the RF cavity filter from its target value. A second important requirement for RF cavity filter performance is the quality of metal plating (copper or silver) on the surface of the filter body housing material. RF waves mainly travel on the surface of the plated metal layer within the skin depth. Therefore, any defects on the plated copper or silver layer would cause interference with RF waves and would destroy or detrimentally affect RF filtering performances. A third critical requirement for RF cavity filter performance is heat dissipation. Since RF cavity filters comprises heat generating electronics, heat buildup can increase the overall temperature of the device, which in turn. can affect the long term reliability and the dimensional stability of the device.

U.S. Patent No. 7,847,658 discloses light-weight low-thermal-expansion polymer foams for radio frequency filtering applications; this patent requires the use of a foamed polymer and a metal coated filler.

A thermoplastic polymer, ULTEM® 3452 (45 % glass fiber and mineral filled polyetherimide), has previously been proposed for use in manufacturing Radio Frequency Systems (RFS). The glass transition temperature (Tg) of ULTEM® 3452 is 217 °C; and the CTE of ULTEM® 3452 is anisotropic in nature. The anisotropic nature of the ULTEM® 3452 material is expected to pose challenges when used in RF cavity filter applications as the material may undergo non-linear deformation in the operating temperature conditions (for example, from about -50 °C to about 85 °C). Non-linear changes in dimensions in all directions will make it very difficult to fine tune the filter for proper operation.

In addition to RF cavity filter articles, other devices which use die cast aluminum or extruded aluminum for its manufacture is a heat sink device for a remote radio head. A typical heat sink for a remote radio head is illustrated in for example the following website: http://www.ejlwireless.com/pdf/Huawei%20RRU3804%20DNA-I%202010%20TOC.pdf. The current material for the heat sink is an extruded or a cast aluminum with a copper heat spreader.

Yet another device that is made of solid aluminum and that would be a desirable candidate for weight reduction can be an enclosure that is used to enclose and protect electronic components. For example, a known enclosure is an enclosure used with Remote Radio Head Model 9341 RRH 40W, commercially available from Alcatel-Lucent. Generally, because of the aluminum enclosure's size, by itself, the aluminum enclosure is a heavy part. Some of the requirements for an enclosure to be functional include the following: The enclosure needs to (1) have good mechanical properties sufficient to withstand a drop test; (2) provide good heat dissipation from internal electronics; (3) have good weathering properties for long service life; (4) provide good UV resistance; and (5) provide good flame resistance.

### SUMMARY

One embodiment of the present invention is directed to a process for preparing a non-foamed cured epoxy composite material useful for various applications such as radio frequency filter applications including the following steps:
(a) providing a curable thermoset epoxy resin composition comprising
   (i) at least one epoxy resin;
   (ii) at least one toughening agent comprising an amphiphilic polyether block copolymer, a core shell rubber, a carboxyl terminated butadiene acrylonitrile elastomer, or mixtures thereof;
   (iii) at least one hardener; and
   (iv) at least one filler;
(b) curing the curable thermoset epoxy resin composition of step (a) to form a cured composite; wherein the curable thermoset epoxy resin composition upon curing provides a cured composite product having a density of less than (<) 2.7 g/cc as measured by ASTM D-792; and
(c) coating at least a portion of the surface of the cured composite of step (b) with an electrically conductive metal layer to form a metalized coating on at least a portion of the surface of the cured composite.

Another embodiment of the present invention is directed to a cured epoxy composite material made by the above process, useful for various applications such as a radio frequency filter application, a heat sink application, an enclosure or a combination thereof for tower top, telecommunication applications.

Still another embodiment of the present invention is directed to a radio frequency filter, a heat sink, or an enclosure made from the above cured epoxy composite material.

### BRIEF DESCRIPTION OF THE DRAWINGS

For the purpose of illustrating the present invention, the drawings show a form of the present invention which is presently preferred. However, it should be understood that the present invention is not limited to the embodiments shown in the drawings.

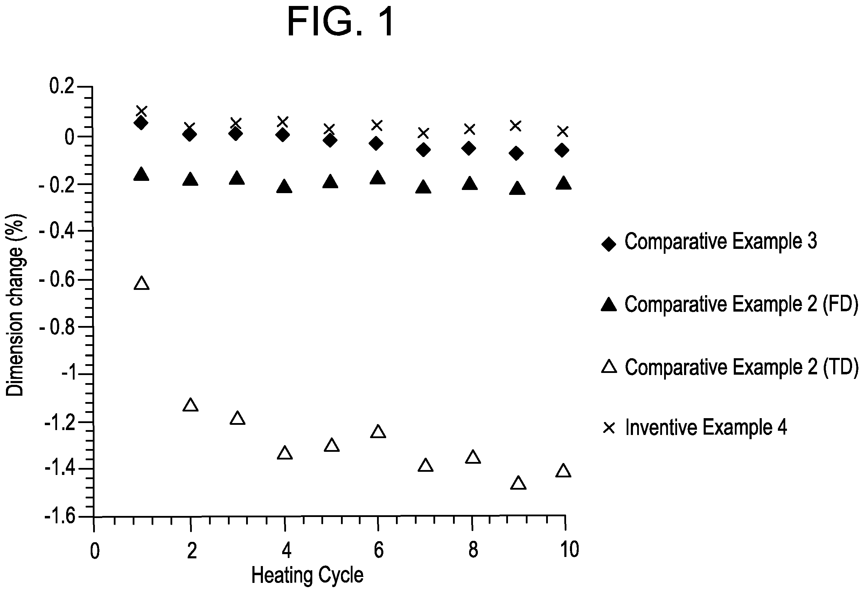

Figure 1 is a graphical illustration of the dimensional change compared to ambient before temperature cycling measured by thermomechanical analysis at 25 °C upon the heating portion of 10 consecutive temperature cycles of -50 °C to 100 °C to -50 °C.

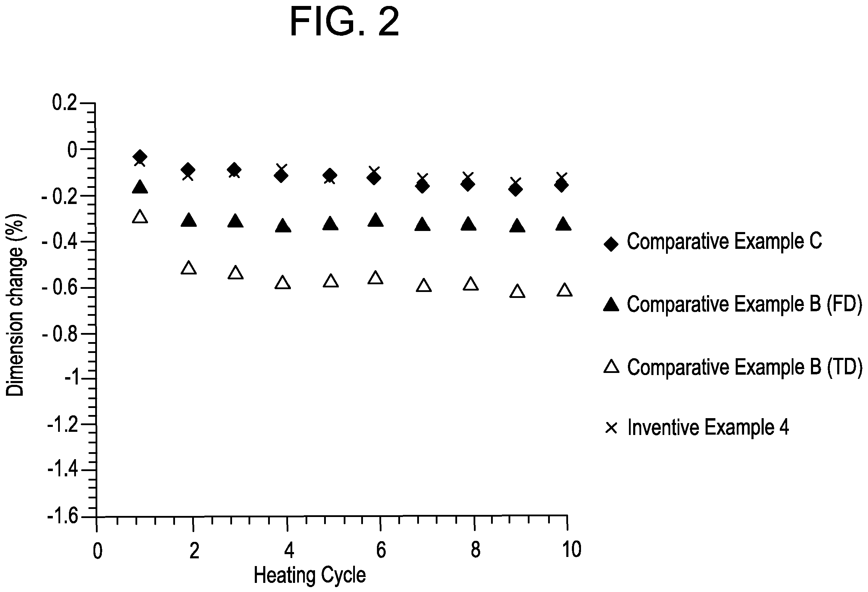

Figure 2 is a graphical illustration of the dimensional change compared to ambient before temperature cycling measured by thermomechanical analysis at 65 °C upon the heating portion of 10 consecutive temperature cycles of -50 °C to 100 °C to -50 °C.

### DETAILED DESCRIPTION

Test methods described herein refer to the most recent test method as of the priority date of this document when a date is not indicated with the test method number. References to test methods contain both a reference to the testing society and the test method number. The following test method abbreviations and identifiers apply herein: ASTM refers to ASTM International, and ISO refers to International Organization for Standards.

"And/or" means "and, or as an alternative". All ranges include endpoints unless otherwise indicated.

In its broadest scope, the present invention includes curing a curable thermoset epoxy resin composition to form a non-foamed cured epoxy composite material, wherein the curable thermoset epoxy resin composition comprises (a) at least one epoxy resin; (b) at least one toughening agent comprising an amphiphilic polyether block copolymer, a carboxyl terminated butadiene-acrylonitrile elastomer, a core shell rubber or mixtures thereof; (c) at least one hardener; and (d) at least one filler; and wherein the cured epoxy composite made from the curable composition has a density of less than 2.7 g/cc and can be metalized by coating at least a portion of the surface of the cured composite with an electrically conductive metal layer, such that the final metalized composite product can be used in various applications including for example radio frequency filters, heat sinks, or electronic components enclosures.

The epoxy resin formulation or composition of the present invention upon curing provides a cured product with a balance of properties comprising glass transition temperature, coefficient of thermal expansion, tensile strength, thermal conductivity, and density.

In addition, the cured product of the present invention comprises a high glass transition epoxy composite that can be metalized without adversely affecting the properties of the metalized coating and the properties of the epoxy composite.

One embodiment of the present invention includes a high Tg epoxy composite material useful for radio frequency cavity filter applications. Some of the unique properties and advantages of the epoxy resin composition of the present invention (discussed in more detail below) include for example wherein the epoxy resin composition has a manageable complex viscosity to facilitate processing prior to curing.

Some of the unique properties and advantages of the epoxy composite material of the present invention (discussed in more detail below) include for example wherein the epoxy composite has an improved glass transition temperature, density, CTE, thermal conductivity, and/or tensile strength; wherein the epoxy composite exhibits non-cracking or non-chipping which provides an indication of the machinability of the composite and an improvement in the surface smoothness of the composite; and wherein the epoxy composite is capable of being metal plated.

Additionally, the present invention uses liquid epoxy resins (LER) and provides a filled thermoset system which, prior to cure, has lower processing viscosity as well as lower processing temperature during the filling of a RF filter mold or shape as compared to known, viscous, solid particulates or fiber filled thermoplastic polymers.

The curable or thermosetting resin composition of the present invention useful for radio frequency filter applications may include one or more epoxy resins. The epoxy resins useful in the present invention may be selected from any known epoxy resin in the art; and may include conventional and commercially available epoxy resins, which may be used alone or in combinations of two or more. For example, an extensive enumeration of epoxy resins useful in the curable composition of the present invention includes epoxides described in Pham et al., Epoxy Resins in the Kirk-Othmer Encyclopedia of Chemical Technology; John Wiley & Sons, Inc.: online December 04, 2004 and in the references therein; in Lee et al., Handbook of Epoxy Resins, McGraw-Hill Book Company, New York, 1967, Chapter 2, pages 257-307 and in the references therein; May, C. A. Ed. Epoxy Resins: Chemistry and Technology, Marcel Dekker Inc., New York, 1988 and in the references therein; and in U.S. Patent No. 3,117,099.

In selecting epoxy resins for the compositions disclosed herein, consideration should not only be given to properties of the final product, but also to viscosity and other properties that may influence the processing of the resin composition. In one embodiment, particularly suitable epoxy resins useful in the present invention are based on reaction products of polyfunctional alcohols, polyglycols, phenols, cycloaliphatic carboxylic acids, aromatic amines, or aminophenols with epichlorohydrin. Other suitable epoxy resins useful for the compositions disclosed herein include reaction products of epichlorohydrin with o-cresol and epichlorohydrin with phenol novolacs. In another embodiment, the epoxy resin useful in the present invention for the preparation of the epoxy resin composition may be selected from commercially available products, such as for example, D.E.R.® 330, D.E.R. 331, D.E.R. 332, D.E.R. 324, D.E.R. 352, D.E.R. 354, D.E.R. 383, D.E.R. 542, D.E.R. 560, D.E.N.® 425, D.E.N. 431, D.E.N. 438, D.E.R. 542, D.E.R. 560, D.E.R. 736, D.E.R. 732 or mixtures thereof. D.E.R resins are commercially available from The Dow Chemical Company.

A few non-limiting embodiments of the epoxy resin useful as a compound in the curable epoxy resin formulation of the present invention may include, for example, bisphenol A diglycidyl ether, tetrabromobisphenol A diglycidyl ether, bisphenol F diglycidyl ether, resorcinol diglycidyl ether, triglycidyl ethers of para-aminophenols, epoxy novolacs, divinylarene dioxides, or mixtures thereof.

Examples of preferred embodiments for the epoxy resin include bisphenol A diglycidyl ether, tetrabromobisphenol A diglycidyl ether, or a mixture of bisphenol A diglycidyl ether and tetrabromobisphenol A diglycidyl ether. Oligomers of the above epoxy resins may also be useful in the present invention. Examples of another preferred embodiment for the epoxy resin can be a mixture of bisphenol A diglycidyl ether, tetrabromobisphenol A diglycidyl ether, and a glycidyl ether prepared by reacting polypropylene glycol and epichlorohydrin. In one embodiment, the curable epoxy resin composition can be useful, for example, for radio frequency filter applications.

In general, at least one of the epoxy resins used the composition of the present invention, has a viscosity of between 1 mPa-s and 100,000 mPa-s in one embodiment, between 5 mPa-s and 50,000 mPa-s in another embodiment, between 10 mPa-s and 25,000 mPa-s in still another embodiment, and between 10 mPa-s and 10,000 mPa-s in yet another embodiment, at ambient temperature (20 °C to 25 °C).

The concentration of the epoxy resin used in the curable composition of the present invention may depend on the hardener used with the epoxy. Generally, the epoxy resin concentration may range from 2 weight percent (wt %) to 60 wt % in one embodiment, from 4 wt % to 46 wt % in another embodiment, from 5 wt % to 37 wt % in still another embodiment, from 5 wt % to 30 wt % in yet another embodiment, from 7 wt % to 30 wt % in even still another embodiment, from 10 wt % to 25 wt % in even yet another embodiment, from 12 wt % to 23 wt % in another embodiment, from 5 wt % to 20 wt % in still another embodiment, and from 13 wt % to 20 wt % in yet another embodiment, based on the total weight of the composition.

When a mixture of two or more epoxy resins are used in the composition of the present invention, for example, a first epoxy resin and a second epoxy resin, the first epoxy resin may be between 1 wt % and 99 wt % of the total epoxy utilized; with the second epoxy resin, and any other additional epoxy resin used, adding up to 100 % of the total epoxy required. For example, a mixture of epoxy resins used in the composition of the present invention, in one embodiment may include a mixture of a tetrabromobisphenol A diglycidyl ether as a first epoxy and a bisphenol A diglycidyl ether as the second epoxy.

Generally, in one embodiment the amount of tetrabromobisphenol A diglycidyl ether may be at least 20 wt % of the total epoxy used in the composition, at least 35 wt % of the total epoxy used in the composition in another embodiment, at least 50 wt % of the total epoxy used in the composition in still another embodiment, and at least 55 wt % of the total epoxy used in the composition in yet another embodiment. In the above mixture of epoxy resins, generally the amount of bisphenol A diglycidyl ether may be at least 80 wt % of the total epoxy used in the composition in one embodiment, at least 65 wt % of the total epoxy used in the composition in another embodiment, at least 50 wt % of the total epoxy used in the composition in still another embodiment, and at least 45 wt % of the total epoxy used in the composition in still another embodiment.

The use of a toughening agent in the curable resin composition of the present invention typically leads to increased toughness when the curable composition is cured to form the cured epoxy composite material as characterized by a variety of methods including critical-stress-intensity factor, K_{1c}, following the ASTM D 5045-99 test method, as well as increased % elongation-to-break following the ASTM D638 test method. In addition to improved toughness of the curable resin composition of the present invention, a toughening agent may be added to the curable resin composition to maintain a high Tg of the cured composite, with no decrease in Tg or only a nominal decrease in Tg (for example, less than 15 % decrease in Tg and more preferably less than 7.5 % decrease in Tg for the higher Tg transition if more than one Tg is exhibited by the composition of the present invention). The toughening agent may also lead to reduced cracking and/or reduced chipping when drilling holes, tapping holes, or machining the cured epoxy composite material made from the curable resin composition of the present invention. In one preferred embodiment, the epoxy composite product of the present invention may be drilled or tapped without substantial chipping or cracking.

The at least one toughening agent comprises an amphiphilic polyether block copolymer, a core shell rubber, a carboxyl terminated butadiene acrylonitrile elastomer or mixtures thereof. For example, the amphiphilic polyether block copolymer useful in the present invention may include FORTEGRA™ 100 which is a polyol derivative commercially available from The Dow Chemical Company. For example, the core shell rubber useful in the present invention may include FORTEGRA™ 301 in which the core shell rubber can be formulated in bisphenol A diglycidyl ether which is commercially available from The Dow Chemical Company. For example, the carboxyl terminated butadiene acrylonitrile elastomer useful in the present invention may include FORTEGRA™ 201 which contains an adduct of bisphenol A diglycidyl ether and carboxyl terminated butadiene acrylonitrile elastomer and is commercially available from The Dow Chemical Company.

The amphiphilic polyether block copolymer useful in the present invention may include one or more polyether block copolymers comprising at least one epoxy miscible polyether block segment derived from an alkylene oxide such as ethylene oxide (EO) and at least one epoxy immiscible polyether block segment derived from an alkylene oxide such as for example 1,2-epoxy butane known commonly as butylene oxide (BO). The immiscible block segment may also be comprised of mixtures of C₃ or higher carbon analogue monomers that are copolymerized together to provide the immiscible block segment.

Examples of the epoxy resin miscible polyether block segment include a polyethylene oxide block, a propylene oxide block, a poly(ethylene oxide-co-propylene oxide) block, a poly(ethylene oxide-ran-propylene oxide) block, or mixtures thereof. Preferably, the epoxy resin miscible polyether block segment useful in the present invention can be a polyethylene oxide block.

Examples of the epoxy resin immiscible polyether block segment include a polybutylene oxide block, a polyhexylene oxide block derived from 1,2-epoxy hexane, a polydodecylene oxide block derived from 1,2-epoxy dodecane, or mixtures thereof. Preferably, the epoxy resin immiscible polyether block segment useful in the present invention can be a polybutylene oxide block.

The amphiphilic polyether block copolymers which can be employed in the practice of the present invention include for example, but are not limited to, a diblock copolymer, a linear triblock, a linear tetrablock, other multiblock structures, a branched block structure, or star block structure.

Preferred examples of suitable block copolymers useful in the present invention include amphiphilic polyether diblock copolymers such as, for example, poly(ethylene oxide)-b-poly(butylene oxide)(PEO-PBO) or amphiphilic polyether triblock copolymers such as, for example, poly(ethylene oxide)-b-poly(butylene oxide)-b-poly(ethylene oxide) (PEO-PBO-PEO).

The concentration of the toughening agent used in the curable compositions described herein may depend on a variety of factors including the equivalent weight of the polymers, filler loading, and the desired properties of the product made from the curable composition. In general, the toughening agent may be used in a sufficient amount to provide the resultant composite sufficient toughness to enable drilling holes for screws in the composite without chipping or cracking of the composite. For example, the amount of toughening agent may range generally from 0.1 wt % to 30 wt % in one embodiment, from 0.1 wt % to 10 wt % in another embodiment, from 0.25 wt % to 10 wt % in another embodiment, from 0.5 wt % to 7 wt % in yet another embodiment, and from 1 wt % to 5 wt % in even still another embodiment, based on the total weight of the curable composition.

Above and below the aforementioned concentrations of toughening agent, the high Tg and improved toughness of the resulting cured epoxy resin composite made from the curable composition of the present invention may not be realized; that is, for example, the advantages of reduced cracking and/or reduced chipping when drilling holes/vias, tapping holes/vias, or machining the cured epoxy composite material made from the curable resin composition of the present invention may not be realized.

The hardener (also referred to as a curing agent or cross-linking agent) useful in the present invention may be any compound having an active group being reactive with the epoxy group of the epoxy resin. The chemistry of such curing agents is described, for example, in *Handbook of Epoxy Resins* and in *Epoxy Resins: Chemistry and Technology* referenced above. The curing agent useful in the present invention includes nitrogen-containing compounds such as amines and their derivatives; oxygen-containing compounds such as carboxylic acids, carboxylic acid terminated polyesters, anhydrides, phenolformaldehyde resins, amino-formaldehyde resins, phenol, bisphenol A and cresol novolacs, phenolic-terminated epoxy resins; sulfur-containing compounds such as polysulfides, polymercaptans; and catalytic curing agents such tertiary amines, Lewis acids, Lewis bases and combinations of two or more of the above curing agents.

Generally, the hardener useful in the present invention may be selected from, for example, but are not limited to, dicyandiamide, substituted guanidines, phenolic compounds, amino compounds, benzoxazine, anhydrides, amido amines, polyamides, polyamines, aromatic amines, carbodiimides, polyesters, polyisocyanates, polymercaptans, urea formaldehyde and melamine formaldehyde resins, diaminodiphenylsulfone and their isomers, aminobenzoates, various acid anhydrides, phenol-novolac resins and cresol-novolac resins, and mixtures thereof.

In one embodiment, the at least one hardener may include one or more of aliphatic amines such as ethanolamine, ethylenediamine, diethylenetriamine (DETA), triethyleneaminetetramine (TETA), 1-(o-tolyl)-biguanide, dicyandiamide, amine-terminated polyols, aromatic amines such as methylenedianiline (MDA), toluenediamine (TDA), diethyltoluenediamine (DETDA), diaminodiphenylsulfone (DADS), one or more of polyphenols such as bisphenol A, bisphenol F, 1,1-bis(4-hydroxyphenyl)-ethane, hydroquinone, resorcinol, catechol, tetrabromobisphenol A, novo lacs such as phenol novolac, bisphenol A novolac, hydroquinone novolac, resorcinol novolac, naphthol novolac, one of more of mercaptans such as mercaptan-terminated polysulfide polymers, Capcure (trademark of Cognis) hardeners, one or more of anhydrides such as phthalic anhydride, trimellitic anhydride, nadic methyl anhydride, methyl tetrahydrophthalic anhydride, methyl hexahydrophthalic anhydride; and mixtures thereof.

In general, the curing agent useful for the curable epoxy resin composition of the present invention may comprise a liquid, cyclic anhydride curing agent selected from one or more cyclic anhydride curing agents known in the art. Cyclic anhydride curing agents useful in the present invention can also contain limited amounts of carboxylic acid(s) functionalities which also can function as a curing agent.

In one embodiment, the anhydride curing agent useful in the present invention may include for example, cyclic anhydrides of aromatic, aliphatic, cycloaliphatic and heterocyclic polycarbonic acids which may or may not be substituted with alkyl, alkenyl, or halogen groups. Examples of anhydride curing agents include phthalic anhydride, tetrachlorophthalic anhydride, tetrahydrophthalic anhydride, methyl tetrahydrophthalic anhydride, hexahydrophthalic anhydride, methyl hexahydrophthalic anhydride, nadic methyl anhydride, succinic anhydride, dodecenylsuccinic anhydride, glutaric anhydride, pyromellitic anhydride, maleic anhydride, isatoic anhydride, benzophenonetetracarboxylic anhydride, and mixtures thereof. Anhydride curing agents described in U.S. Patent No. 6,852,415, may also be used.

As an illustration of one embodiment of the present invention, nadic methyl anhydride can be used as the cyclic anhydride curing agent in the composition of the present invention. Nadic methyl anhydride is a liquid cyclic anhydride hardener which has particularly desirable attributes for the formulations of the present invention such as being a liquid at room temperature, and having a viscosity of less than 300 mPa-s at 25 °C. Use of nadic methyl anhydride in the hardener for the formulation for the present invention may also advantageously provide good wettability of fillers and facilitate adhesion of filler to cured epoxy resins. Use of nadic methyl anhydride in the hardener for the formulation for the present invention may also advantageously provide other uses such as generally resulting in low exothermic behavior during cure and low shrinkage while the formulation of the present invention is being cured. Additionally, use of nadic methyl anhydride in the hardener of the present invention generally may lead to an increase in the Tg of the cured product of the present invention as compared to other liquid anhydride hardeners.

In another embodiment, the hardener used in the composition of the present invention may comprise methyl tetrahydrophthalic anhydride (MTHPA), alone, or in combination with nadic methyl anhydride (NMA).

Generally, the amount of curing agent used in the present invention may be in the range of from 0.5 wt % to 50 wt % in one embodiment, from
1.5 wt % to 42 wt % in another embodiment; from 2.5 wt % to 34 wt % in still another embodiment; from 2.6 wt % to 32 wt % in yet another embodiment, from 7 wt % to 35 wt % in even still another embodiment, from 10 wt % to 30 wt % in yet another embodiment; from 12 wt % to 25 wt % in another embodiment; and from 14 wt % to 23 wt % in yet another embodiment based on the total weight of the composition. Preferred embodiments of the curing agents may include for example anhydride curing agents and active hydrogen curing agents. Above and below the aforementioned concentrations of curing agent, the high Tg and improved mechanical properties of the resulting cured epoxy resin composite made from the curable composition of the present invention may not be realized.

The curable epoxy resin composition of the present invention includes at least one filler. The mechanical or thermomechanical performance (that is, such as storage modulus, tensile strength; thermal conductivity; and coefficient of thermal expansion as measured at a temperature representative of typical operating temperatures of indoor or outdoor telecommunication equipment) of the cured filled material may be improved by incorporating filler into the curable composition. The use of fillers in the curable composition can also provide other advantages such as reduced shrinkage during curing of the formulation as well as other attributes such as reduced water absorption, improved environmental aging, and other attributes in a cured formulation as is known in the art. In addition, the use of fillers in the curable composition can provide still other advantages such as improved flame retardancy (FR).

The filler useful in the curable composition of the present invention may include for example one or more surface treated fillers to improve filler and polymer interaction, one or more non-surface treated fillers, one or more electrically and/or thermally conductive fillers, one or more non-conductive fillers, and mixtures thereof. For example, fillers falling within the following classes may be used in the present invention: metal particles, nano-scale particles, metal oxides, metal nitrides, metal carbides, metal hydroxides, metal carbonates, metal sulfates, natural and synthetic minerals mainly silicates, and aluminum silicates; or mixtures thereof.

Specific examples of the fillers useful in the present invention may include, quartz, silica, silicon oxide, fused silica, fused quartz, natural silica, synthetic silica, natural aluminum oxide, synthetic aluminum oxide, aluminum trihydroxide, aluminum -oxide-hydroxide, magnesium hydroxide, aluminum hydroxide oxide, boron nitride, aluminum nitride, silicon nitride, silicon carbide, mica, calcium carbonate, lithium aluminum silicate, zinc oxide, aluminum nitride, mullite, wollastonite, talcum, glimmer, kaolin, bentonite, boehmite, xonolit, andalusite, zeolithe, dolomite, vermiculite, muscovite, nephheline, albite, microline, slate, aluminum powder, silver, graphite, synthetic graphite, natural graphite, amorphous graphite, flake graphite, vein graphite, expandable/intumescent graphite, antimony oxides, borates (including zinc borates and sodium borates), molybdates (including calcium molybdate and zinc molybdate), stannates (including zinc stannate), phosphinates (including aluminum phosphinates, aluminum phosphinite), ammonium polyphosphate, melamine polyphosphate, melamine salts, zinc sulfide, red phosphorous, layered clays (including montmorillonite and hectorite) gold, carbon, single or multi-wall carbon nanotubes, graphene, glass powder, glass fibers, glass fabric, glass sheets, carbon fibers, other organic or inorganic particulate fillers or mixtures thereof. The filler may be either added into the curable composition in the filler's end state or the filler may be formed *in-situ*.

In one embodiment of the present invention, at least one of the fillers utilized in the present invention comprises a surface treated filler either before incorporation in the curable composition or *in-situ* during the compounding of the formulation. Examples of various surface treatments of fillers include fatty acids, silane coupling agents, titanates, zirconates, aluminates, or silazane compounds.

In one embodiment of the present invention, for example, the filler may be surface treated with silane, often referred to as silanized, and the functionality or modification of the resulting filler can be such that the filler is compatible with, or can react as part of, the epoxy curing process. In another embodiment, the fillers may be treated by silane coupling or silane sizing agents. In general, the silane coupling agent contains at least one alkoxy group to facilitate surface treatment and optionally bonding to the inorganic filler. In yet another embodiment, the silane coupling agent may contain another group including for example epoxy, amine, hydroxyl, carboxyl, vinyl, allyl, hydrosilyl (that is, SiH), or other functionalities that can react with the epoxy formulation or be compatible or miscible with the epoxy formulation.

Examples of fillers treated with the silane coupling agent include 3-glycidoxypropyltrimethoxysilane which is commercially available from Dow Corning Corporation under the tradename Dow Corning Z-6040 Silane; or epoxy-silane treated quartz and fused quartz commercially available from Quarzwerke under the tradename SILBOND with different grades described as 126 EST, W6 EST, W12 EST, 100 EST, 600 EST, FW 61 EST, FW 12 EST, FW 100 EST, FW 300 EST, FW 600 EST and 800 EST.

As aforementioned, the filler component used in the present invention formulation may be a combination of fillers which individually may or may not be surface treated. In the embodiment wherein the filler comprises an epoxy-silane treated quartz or fused quartz, for example, the epoxy-silane treated quartz or fused quartz may be 100% of the filler utilized in the composition of the present invention; or another one or more different fillers may be used in combination with the epoxy-silane treated quartz.

The filler material useful in the present invention may include fillers with morphologies such as platelets, fibers, spheres, granules, needles, which may be crystalline, semi-crystalline or amorphous, or any combination thereof. These fillers with different size distributions and different shapes may be combined to have a synergistic effect on the viscosity of the curable composition; and on the coefficient of thermal expansion (CTE), modulus, strength, and/or heat or thermal conductivity of the cured composition.

The particle size of the filler material generally may range from nano to conventional micro size. In general, the particle size of the filler material of the present invention, when used in granular form, has an average particle size, often designated d_{50%} sufficient to promote a balance of acceptable processing viscosity prior to cure and to promote a balance of acceptable thermomechanical properties after cure. For example, the average particle size, d_{50%} for granular filler may be generally in the range of from 0.0005 micron (µm) to 500 (µm in one embodiment, from 0.1 (µm to 100 (µm in another embodiment, from 1 µm to 50 µm in another embodiment, from 3 µm to 40 µm in still another embodiment, and from 12 µm to 25 µm in yet another embodiment.

The filler or mixture of fillers used in the present invention may optionally have a thermal conductivity greater than an unfilled cured epoxy resin which can be greater than 0.2 W/mK measured at 25 °C. In the present invention, heat dissipation from an RF filter is required using conventional industry methods; and thus, the thermal conductivity of the filler useful in the present invention can be generally greater than (>)0.5 W/mK in one embodiment, greater than 1 W/mK in another embodiment, and greater than 2 W/mK in another embodiment. As one illustrative embodiment, the thermal conductivity of the filler may be from 0.2 W/mK to 4000 W/mK; from 0.2 W/mK to 1000 W/mK in another embodiment; from 0.2 W/mK to 600 W/mK in still another embodiment, from 0.2 W/mK to 500 W/mK in yet another embodiment; from 0.2 W/mK to 200 W/mK in even still another embodiment, and from 0.2 W/mK to 100 W/mK in even yet another embodiment.

Generally, the thermal conductivity of the cured epoxy composite made from the curable composition may be greater than 0.20 W/mK in one embodiment, greater than 0.5 W/mK in another embodiment, greater than 0.75 W/mK in still another embodiment, and greater than 1.0 W/mK in yet another embodiment. As one illustrative embodiment, the thermal conductivity of the cured epoxy composite may be from 0.20 W/mK to 300 W/mK in one embodiment, from 0.35 W/mK to 300 W/mK in another embodiment; from 0.35 W/mK to 250 W/mK in still another embodiment; from 0.35 W/mK to 50 W/mK in yet another embodiment; from 0.7 W/mK to 10 W/mK in yet another embodiment; and from 0.90 W/mK to 5 W/mK in even still another embodiment.

Filler loadings useful in the present invention may vary and depends on the type of filler used. Generally, the concentration of the total filler present in the curable composition of the present invention may be from greater than 35 wt % to 90 wt % in one embodiment, from greater than 40 wt % to 90 wt % in another embodiment, from greater than 45 wt % to 80 wt % in still another embodiment, from 55 wt % to 75 wt % in yet another embodiment, from 60 wt % to 75 wt % in even still another embodiment, and from 60 wt % to 70 wt % in even yet another embodiment; based on the weight of the total composition. Below a filler loading of 35 wt %, the composition containing such filler loading can be expected to result in a composite having a higher CTE which moves away from the desired low CTE of the present invention; and above a filler loading of 90 wt %, no further advantage can be seen in the composite of the present invention regarding CTE.

In one preferred embodiment, and in order to approach the CTE of aluminum metal, such as by using a quartz filler, a fused quartz filler, or mixture of quartz filler and fused quartz filler, the filler loading can be generally greater than 45 wt %. In addition to the choice of base resin used and a composition leading to a high Tg, the filler level of the composition can be a significant factor in obtaining a low CTE of the resultant composite made from the composition.

The curable resin composition of the present invention may optionally include at least one catalyst to facilitate the reaction of the epoxy resin compound with the curing agent. The use and function of catalysts is described, for example, in *Handbook of Epoxy Resins* and in *Epoxy Resins: Chemistry and Technology* referenced above. The catalyst, useful as an optional component in the composition of the present invention, may include catalysts well known in the art, such as for example, catalyst compounds containing amine, phosphine, heterocyclic nitrogen, ammonium, phosphonium, arsonium, sulfonium moieties, and any combination thereof. Some non-limiting examples of the catalyst of the present invention may include, for example, ethyltriphenylphosphonium; benzyltrimethylammonium chloride; triflates and heterocyclic nitrogen-containing catalysts including those that are not complexes described in U.S. Patent No. 4,925,901; imidazoles; triethylamine; and any combination thereof.

For example, the catalyst may include tertiary amines such as triethylamine, tripropylamine, tributylamine, benzyldimethylamine, and mixtures thereof; imidazoles such as 2-methylimidazole, 1-methylimidazole, 2-ethyl-4-methyl imidazole; and mixtures thereof; organo-phosphines; acid salts; organic metallic salts; cationic photoinitiators, such as diaryliodonium salts including Irgacure™ 250 available from Ciba-Geigy or triarylsulfonium salts such as Cyracure* 6992 available from The Dow Chemical Company; and mixtures thereof.

In another embodiment a "super acid" catalyst can be used in a formulation where the reactants which contain epoxy groups and potentially other reactants that contain hydroxyl groups. The catalyst acts as a "hardener". The system can either be a 2-pack system where the catalyst is, for example, added to the hydroxyl compounds, where the catalyst is either inactive or slow reacting at ambient temperatures, or where the catalyst is, for example, "blocked" at ambient temperatures and is "de-blocked" when heated. De-blocking can be exemplified for example by using di-ethyl ammonium triflate which is, for example, non-reactive as salt but active when amine volatilizes. A non-volatile blocked catalyst can be for example a sulfonium hexafluro-antimonate, with a third chain attached to the sulfur. Such a formulation could also contain a glycidyl epoxy and/or a cycloaliphatic epoxy. Glycidyl epoxies such as for example D.E.R. 332, an epoxy resin having an EEW of 171 and commercially available from The Dow Chemical Company, would add "toughening" (for example, dart drop impact, non-cracking) to the composite made from the formulation. A cycloaliphatic epoxy would both raise Tg and reduce formulation viscosity.

The curing catalyst may be added to the epoxy resin component, and/or the hardener component; or alternatively, the curing catalyst may be blended into the curable composition.

The concentration of the curing catalyst used in the present invention may be less than 3 wt %. Generally, the curing catalyst can be present in the curable composition at a concentration of from 0.005 wt % to 3 wt % in one embodiment; from 0.025 wt % to 2 wt % in another embodiment, from 0.01 wt % to 1.5 wt % in yet another embodiment, from 0.1 wt % to 1.0 wt % in still another embodiment, and from 0.2 wt % to 0.8 wt % in even yet another embodiment, based on the total weight of the curable composition. Use of lower concentrations of the catalyst typically does not provide a sufficient catalytic effect, resulting in too slow reactivity of the curable composition. Use of higher concentrations of the catalyst typically results in too high reactivity of the curable composition.

The curable resin composition of the present invention may optionally include at least one flame retardant (FR) component to provide flame retardancy to the cured composite product made from the curable resin composition of the present invention. The FR component, useful in the preparation of the composition is as an optional component of the present invention and may include for example, one or more reactive and non-reactive FR compounds or ingredients well known in the art to provide flame retardancy. For example, one or more halogen-containing compounds such bromine-containing compounds, or non-halogen-containing compounds such as phosphorous-containing compounds can be used in the curable resin composition. Some combinations of two or more of the above FR compounds may advantageously function synergistically in providing flame retardancy.

"Reactive FR compounds", as used herein, includes FR compounds that are capable of being chemically bonded or attached to a cured epoxy resin and/or hardener; and can become part of a crosslinked epoxy network. "Non-reactive FR compounds", as used herein, includes FR compounds useful as additives that are capable of being dissolved or partially dissolved in a crosslinked epoxy network or capable of being phase-separated from a crosslinked epoxy network or are effectively a filler in a crosslinked epoxy network.

The FR components used in the present invention may be present in the curable resin composition at a concentration that provides a balance of properties to the resulting composite made from the curable composition of the present invention, such as for example the composite's thermal, mechanical, and thermomechanical properties. For example, the concentration of a FR component or a mixture of two or more FR components, generally can be sufficient to allow the composite to satisfy at least a V-2 rating as determined by UL 94 test, in one embodiment; at least a V-1 rating as determined by UL 94 test, in another embodiment; and at least a V-0 rating as determined by UL 94 test, in still another embodiment.

The flame retardants useful in the present invention may function by different modes (such as endothermic degradation, thermal shielding [for example, char formation], gas phase radical quenching, dilution of the gas phase, and the like) or by multiple modes such as by one or more of the aforementioned modes; and it is often desirable to utilize two different flame retardants in a composition such that the two different flame retardants function in different modes and/or such that the two different flame retardants in combination function synergistically.

In general, the flame retardant reactant compound or flame retardant additive useful in the present invention may include for example a brominated diglycidylether, an organophosphorous compound, aluminum trihydrate, ammonium polyphosphate, or mixtures thereof.

A few non-limiting examples of FR compounds that may be used in the curable epoxy resin formulations of the present invention may include aluminum trihydrate; magnesium hydroxide; antimony oxide; red phosphorus; ammonium polyphosphate; zinc borate; zinc molybdate; tetrabromobisphenol A; tetrabromobisphenol A diglycidylether and its oligomers; triglycidyl phosphate; 2-(6-oxido-6H-dibenzo[c,e][1,2]oxa-phosphorin-6-yl) 1,4-benzenediol (DOPO-HQ); 9,10-dihydro-9-oxa-10-phosphaphenanthrene-10-oxide (DOPO) and its derivatives; phosphoramidates; 5,5-dimethyl-[1,3,2]dioxaphosphinane 2-oxde (DDPO) and its derivates; dimethyl phosphite and other organophosphates; diethyl phosphinic acid and other organophosphinic acids; ethylphosphonic acid and other organophosphonic acids; tris(4-hydroxyphenyl)phosphine oxide and other organophosphine oxides; bis(2-hydroxyphenyl)phenyl phosphinate and other organophosphinates; melamine polyphosphate; aluminum diethylphosphinate and other metal phosphinates; triphenylphosphate; resorcinol bis(diphenylphosphate); bisphenol A (diphenyl phosphate), other organophosphates, and oligomers thereof; dimethyl methylphosphonate, other organophosphonates, and oligomers thereof; and mixtures thereof.

Other examples of suitable flame retardants useful in the present invention and their classes may be found, for example, in a paper entitled "Flame Retardants-101 Basic Dynamics-Past Efforts Create Future Opportunities", presented at Fire Retardant Chemicals Association, Baltimore Marriot Inner Harbour Hotel, Baltimore MD, March 24-27, 1996; Materials 2010, 3, 4300-4327; U.S. Patent No. 6,645,631; WO 2004118604; and WO2008144252.

One example of a flame retardant compound useful in the present invention may include tetrabromobisphenol A diglycidyl ether, aluminum trihydrate, aluminum diethylphosphinate, ammonium polyphosphate, or mixtures thereof. The concentration of the FR compound present in the curable composition may depend on the specific FR compound used and the enduse application in which the curable composition may be used. However, such concentrations can be determined by the skilled artisan.

Other optional components, that may be useful in the present invention, include conventional components normally used in resin formulations. For example, an assortment of optional additives that can be added to the reactive curable epoxy resin composition of the present invention may include, other resins, stabilizers, plasticizers, catalyst de-activators, dyes, pigments, thixotropic agents, photo initiators, latent catalysts, inhibitors, solvents, surfactants, fluidity control agents, diluents, flexibilizing agents, processing aides, dispersing/wetting agents, air release agents, reactive diluents (low viscosity monoepoxy or polyepoxy materials that aid processing as described in the books describing epoxy resins previously referenced above), other toughening agents not previously described, other halogen-containing fire retardants, other halogen-free flame retardants, other synergists to improve the performance of the flame extinguishing ability, adhesion promoters such as modified organosilanes (epoxidized, methacryl, amino), acetylacetonates, or sulfur containing molecules; wetting and dispersing aids such as modified organosilanes, Byk 900 series and Byk W-9010, modified fluorocarbons; air release additives such as Byk-A 530, Byk-A 525, Byk-A 555, Byk-A 560; surface modifiers such as slip and gloss additives (a number of which are available from Byk-Chemie), or mixtures thereof.

The amount of the optional additives used in the present invention can be such that (i) the Tg of the resultant cured composite can be greater than or equal to 100 °C in one embodiment, or greater than or equal to 130 °C in another embodiment; and (ii) the CTE of the resultant cured composite can be less than or equal to 80 ppm/°C in one embodiment, less than or equal to 50 ppm/°C in another embodiment, or less than or equal to 40 ppm/°C in still another embodiment. For example, the concentration of the optional additives used in the present invention may range generally from 0 wt % to 10 wt % in one embodiment, from 0.01 wt % to 5 wt % in another embodiment, from 0.1 wt % to 2.5 wt % in still another embodiment, and from 0.5 wt % to 1.0 wt % in yet another embodiment, based on the weight of all the components in the composition.

The process for preparing the epoxy resin composition useful for the manufacture of RF filters includes admixing (i) at least one epoxy resin; (ii) at least one toughening agent comprising an amphiphilic polyether block copolymer, a core shell rubber, a carboxyl terminated butadiene acrylonitrile elastomer, or mixtures thereof; (iii) at least one hardener; (iv) at least one filler; and (v) optionally, at least one cure catalyst. For example, the curable epoxy resin composition of the present invention can be prepared, for example, by admixing in a vessel the epoxy resin, the at least one toughening agent, a curing agent, a filler, an optional curing catalyst, and any other desirable optional additives; and then allowing the components to formulate into an epoxy resin composition. Any of the above-mentioned optional assorted formulation additives, for example an inert organic solvent or gas releasing agent, may also be added to the composition during the mixing or prior to the mixing to form the composition.

For example, the curable epoxy resin composition of the present invention can be achieved by blending with or without vacuum in a Ross PD Mixer (Charles Ross), a FlackTek Speedmixer or other mixer known in the art that wets out the filler with and distributes evenly the resin components (i)-(v) above. The above mentioned elements can generally be added in most any sequence, various combinations, and various times of additions as is convenient and desired. For example, to lengthen pot-life the optional cure catalyst (v) maybe added last or at later time during mixing and optional degassing, but prior to casting the formulation. Any of the above-mentioned optional assorted formulation additives, for example an additional epoxy resin, may also be added to the composition during the mixing or prior to the mixing to form the composition.

In one embodiment, one or more of the components (i)-(v) above of the formulation may be premixed. For example, the catalyst may be premixed in the hardener and then the premixed components may be added into the formulation. In another embodiment, components (i) and (ii) are premixed.

For the formulations of the present invention, degassing of the formulation is an option for the present invention and may be achieved via methods know in the art. Typically, the degassing may be carried out by application of vacuum in some mixing apparatus for the formulation, including the individual components as well as mixtures of individual components or by applying appropriate vacuum directly to the mold. The range of vacuums, ramps and steps of vacuums, and timing of vacuum application to effectively degas a formulation prior to casting and curing depends on a variety of factors as is known in the art which relate for example to the temperature, viscosity of the formulation, mass of formulation, degassing vessel geometry and its quality of mixing and the like. In general, it is desired to apply a vacuum at some point during the mixing of resin components (i)-(v) and vacuum can be defined herein, for example, as anything less than atmospheric pressure.

Degassing may occur in the same or separate devices and/or vessels as may be used to initially mix or hold any of the components (i) - (v) as well as optional additives. Mixing or agitation can be normally performed when degassing. Most any vacuum can be applied, but rate of degassing improves as lower vacuums are utilized. Degassing can be generally done at less than 300 millibar in one embodiment, less than 100 millibar in another embodiment, less than 50 millibar in still another embodiment, and less than 20 millibar in yet another embodiment. As one illustrative embodiment, degassing may be carried out at from 0.1 millibar to 900 millibar. It is generally preferred to have some lower limit of applied vacuum for both economic considerations and the desire to minimize volatilization of a component which depends on the component and the temperature of the component. It is preferred that some vacuum more than 0.5 millibar be utilized in degassing and more preferred that vacuum more than 1 millibar be utilized.

All the components of the epoxy resin composition are typically mixed and dispersed; and optionally degassed at a temperature enabling the preparation of an effective curable epoxy resin composition such that when cured provides a cured product having the desired balance of properties required for use in, for example, RF filter applications. The temperature during the mixing of all components may be generally from 10 °C to 110 °C in one embodiment, from 20 °C to 90 °C in another embodiment, and from 40 °C to 80 °C in still another embodiment. Lower mixing temperatures help to minimize reaction of the epoxy resin and hardener components to maximize the pot life of the formulation, but higher mixing temperatures in the short term can lower the formulation viscosity and facilitate mixing, degassing, and transfer of the formulation before being cured.

In general, the viscosity of the curable epoxy resin composition at the transfer or casting temperature into a mold or form can be any viscosity value at which the formulation flows. For example, the complex viscosity of the complete formulation at the temperature at which the formulation is being transferred or cast may be less than 200,000 mPa-s at 80 °C in one embodiment, less than 100,000 mPa-s in another embodiment, less than 50,000 mPa-s in still another embodiment, and less than 25,000 mPa-s in yet another embodiment. In even yet another embodiment, the viscosity of the complete epoxy resin formulation may range from 200 mPa-s to
25,000 mPa-s.

As one general illustrative embodiment of the present invention, the complex viscosity of the epoxy resin composition of the present invention, prior to curing, which is useful in making the epoxy composite generally may be for example from 500 mPa-s to 200,000 mPa-s in one embodiment, from 1,000 mPa-s to
100,000 mPa-s in another embodiment, and from 2,000 mPa-s to 25,000 mPa-s in still another embodiment, as measured at 80 °C.

It is generally desired that the complete curable epoxy resin composition or formulation of the present invention be mixed, degassed, and transferred to be cured in the mold, form, shape or apparatus that the formulation will be generally used in less than 2 days in one embodiment, less than 1 day in another embodiment, and less than 12 hours in still another embodiment, when held at ambient temperature (about 25 °C) up to 60 °C. As a general illustrative embodiment of the present invention, the formulation will be generally used, for example, in from 0.02 hours to 2 days. However, in another preferred embodiment, the complete and degassed formulation has transfer started immediately, rather than storing, to be cured in the mold, form, or specific shape in which the RF material will be generally used.

As known in the art, the pot life (or shelf life) of a complete formulation can be dependent not just on the temperature at which the formulation is held but also on the amount and type of catalyst that can be included in the formulation with lower concentration of catalyst typically extending the pot life of the formulation. For extended pot life, the blended compound formulation can be typically stored at sub-ambient temperatures to maximize shelf life and optionally without containing catalyst. Acceptable temperature ranges for storage include for example from -100 °C to 25 °C in one embodiment, from -70 °C to 10 °C in another embodiment, and from -50 °C to 0 °C in still another embodiment. As an illustration of one embodiment, the temperature of storage may be -40 °C.

The curing of the thermosettable composition may be carried out at a predetermined temperature and for a predetermined period of time and in a series of temperature ramps and temperature steps sufficient to cure the composition. The curing of the formulation may be dependent on the hardeners used in the formulation as well as optional catalyst and their amounts as well as other additives. Using more than one temperature step in the curing of the formulation in which some of the steps only partially cure or gel the formulation are hypothesized to facilitate the development of properties of the fully cured formulation. Such a temperature stepped process can be hypothesized to better manage the homogeneity, shrinkage, and stresses that occur during the cure of the formulations of the present invention and can lead to a more consistent or better mechanically performing material for RF filters, heat sinks, or enclosures. Whatever the cure profile, it is generally recognized by those skilled in the art that the final cure temperature should generally exceed the glass transition temperature, Tg, of a fully cured epoxy/hardener system. After curing or post-curing the composition, the process may include a controlled cooling that may include single or multiple temperature ramps and temperature steps to minimize the development of stress and possible defects in the cured material.

In one embodiment, a partially cured (B-stage) thermosetting resin composition of the present invention may be first produced followed by complete curing of the composition (C-stage). The curing can be carried out *via* thermal cure. For example, the temperature of curing or series of one or more curing steps for the formulation may be generally from 10 °C to 300 °C in one embodiment; from 10 °C to 250 °C in another embodiment, from 25 °C to 250 °C in still another embodiment, from 30 °C to 225°C in yet another embodiment; from 50 °C to 200 °C in even still another embodiment; and from 50 °C to 120 °C in still another embodiment.

The curing time may be chosen depending on the size and shape of the substrate. Generally, the curing time may be between 1 minute to 96 hours in one embodiment, between 5 minutes to 72 hours in another embodiment, between 10 minutes to 48 hours in still another embodiment; between 20 minutes to 24 hours in yet another embodiment, and between 1 hour and 4 hours in still another embodiment. Below a period of time of 1 minute, the time may be too short to ensure sufficient reaction under conventional processing conditions; and above 96 hours, the time may be too long to be practical or economical. The size and shape of cured epoxy formulation as well as the components of the epoxy formulation play a role in the cure profiles utilized as known to those skilled in the art. Below a period of time of 1 minute, the time may be too short to ensure sufficient reaction under conventional processing conditions; and above 72 hours, the time may be too long to be practical or economical.

At the C-stage, generally more than 70 mol % of the thermosetting moieties of the resin have reacted in one embodiment, more than 80 mol % of the thermosetting moieties of the resin have reacted in another embodiment, and more than 90 mol % of the thermosetting moieties of the resin have reacted.

In one embodiment, it is advantageous to partially cure or gel the composition at one or more temperature steps or ramps. For example, a first curing temperature step or ramp of from 10 °C to 250 °C may be used; and then at least one further curing/heating step or ramp of from 120 °C to 300°C can be used. In another embodiment of at least a two step curing process, the curing stage of the composition may include for example a first curing step at a temperature of from 70 °C to 120 °C and a second curing step at a temperature of from 130 °C to 160 °C. In still another embodiment, a third curing step can be used after the above first and second steps are carried out wherein the temperature of the third step can be from from 175 °C to 250 °C. In any of the steps/ramps described above, the time of heating at the desired temperature can be from 1 minute to 96 hours.

In still another embodiment, an initial gel time for "green cure" may be from 12 minutes to 78 minutes at 100 °C to 120 °C. In a subsequent step; the curing can be continued at from 2 hours to 4 hours at 140 °C to 160 °C; and optionally at 8 hours at greater than 200 °C, for example, for epoxy novolac and cycloaliphatic systems.

If the formulation or composition is cured too fast or at a temperature too high for a particular temperature step or ramp then it may be more likely to result in decreased performance of the cured material as well as the device in which the cured material is utilized. Decreased performance can arise from, but is not limited to, defects in the resulting cured composition which can lead to decreased performance or failure in the formulation or the device in which the formulation is utilized. If the formulation is cured too slowly, a decreased performance or failure in performance of the formulation may arise; or the device in which the formulation is utilized may have substantive uneven distribution of filler(s) which can detrimentally affect the performance of the device. Examples of such defects include cracks, bubbles, substantive uneven distribution of filler(s), and the like.

The processes to make parts using the epoxy resin formulations of the present invention, that is, curing the curable composition of the present invention, include for example, but are not limited to, vacuum casting, Liquid Injection Molding (LIM), Reactive Injection Molding (RIM), Resin Transfer Molding (RTM), Automatic Pressure Gelation (APG), and the like.

One embodiment of the process of manufacturing the RF filter body includes wherein the filter can be molded and cured using the proposed epoxy compositions to be close to final geometry, requiring only some additional machining and surface treating to result in a semi-finished product ready for metal plating followed by installation of other parts and accessories and then final tuning. Another embodiment of the process of manufacturing the RF filter body includes wherein a proposed epoxy resin composition of the present invention can be molded and cured into blocks of desired dimensions, then the final geometry of the molded and cured blocks can be machined to semi-final target parts to be followed by the same steps as described previously. In either of the above embodiments, the RF filter body may be made including a plurality of holes for fastening a cover plate by means of screws and sealing the interior electronics such as resonators and connector components with screws. In one embodiment, the holes may be molded-in during manufacturing of the RF filter body, eliminating the need for drilling holes post-molding. In another embodiment, the RF filter body may be molded with using insert molding technology, which includes for example threaded inserts molded into the body, eliminating the need for post-molding drilling and tapping of holes.

The thermoset product of the present invention (that is the cross-linked epoxy composite made from the present invention formulation) shows several desirable properties. For example, the present invention provides a thermoset system which is preferably isotropic in terms of mechanical properties and/or coefficient of thermal expansion by contrast to known filled thermoplastic polymers. Dimensional stability and isotropicity are two desirable properties for certain applications such as RF filters because signal tuning of the filter depends on property stability.

"Dimensional stability" with reference to a device herein means thermal dimensional stability over the operating temperature of the device as indicated by the coefficient of thermal expansion (CTE) of the material in the device.

"Isotropicity" herein means an average orientation property value which is substantially the same measurement in the x, y, and z direction of measurement. The x, y, and z direction of measurements are generally within 60 percent (%) from each other in one embodiment, within 75 % from each other in another embodiment, and within 90 % from each other in still another embodiment.

In another embodiment, "isotropicity" herein means, when heated within the operating temperature range, dimensional change as defined by the CTE of the material is substantially similar in all dimensions. "Substantially similar" herein means a CTE change that can be generally less than 60 % in one embodiment, less than 50 % in another embodiment, less than 40 % in still another embodiment, less than 30 % in yet another embodiment, less than 25 % in even still another embodiment, and less than 10 % in even yet another embodiment. In still another preferred embodiment, the CTE change can be essentially zero.

One illustrative embodiment and advantage of the present invention, includes, for example, wherein the glass transitions (Tg) of the epoxy composite generally may be greater than 100 °C For example, the cured epoxy resin product of the present invention may have a Tg generally from 100 °C to 300 °C in one embodiment; from 120 °C to 250 °C in another embodiment; from 130 °C to 200 °C in yet another embodiment; from 135 °C to 180 °C in still another embodiment; and from 140 °C to 170 °C in even yet another embodiment, as measured by differential scanning calorimetry.

The Tg may be measured using a differential scanning calorimeter (DSC) by scanning at 10 °C/minute from near ambient temperature (0 °C to 25 °C) to some temperature greater than Tg, for example typically to a temperature of 250 °C with a first heating cycle, a cooling cycle, and a second heating cycle. The Tg can be determined from the half-height of the 2^{nd} order transition from the second heating cycle. Tg for the cured material of the present invention is the Tg for the continuous epoxy/hardener phase; and if the a toughening agent is phase-separated in the epoxy/hardener phase, the Tg is the higher 2^{nd} order transition associated with the epoxy/hardener component.

The density of the cured epoxy composite is less than 2.7 g/cc (which is the density of aluminum, the incumbent metal). For example, the density of the epoxy composite of the present invention may be generally less than 2.5 g/cc in one embodiment; less than 2.3 g/cc in another embodiment; and less than 2.2 g/cc in still another embodiment, for lightweight versus incumbent metal technology. In other examples, the density of the epoxy resin composite of the present invention may be generally from 1.2 g/cc to 2.7 g/cc in one embodiment, from 1.2 g/cc to 2.5 g/cc in another embodiment, from 1.2 g/cc to 2.2 g/cc in still another embodiment, from 1.4 g/cc to 2.1 g/cc in yet another embodiment, from 1.6 g/cc to 2.0 g/cc in even still another embodiment, from 1.8 g/cc to 2.0 g/cc in even yet another embodiment, and from 1.7 g/cc to 1.9 g/cc in even still one other embodiment, as measured by ASTM D-792.

One objective of the present invention to provide an epoxy resin composite which is substantially lighter than aluminum. "Substantially lighter", with reference to the epoxy resin composite of the present invention, herein means at least 10 % lighter than aluminum in one embodiment, at least 20 % lighter than aluminum in another embodiment, at least 30 % lighter than aluminum in still another embodiment, at least 40 % lighter than aluminum in yet another embodiment, and at least 50 % lighter than aluminum in even still another embodiment. In another embodiment, the epoxy resin composite of the present invention can be from 10 % to 50 % lighter than aluminum.

Still another illustrative embodiment and advantage of the present invention, can be wherein the CTE of the epoxy composite generally may be less than 80 ppm/°C in one embodiment, from 0 ppm/°C to 50 ppm/°C in another embodiment, from 10 ppm/°C to 50 ppm/°C in still another embodiment, and from 20 ppm/°C to 45 ppm/°C in yet another embodiment, over the use temperature range from -50 °C to 85 °C, where the CTE must be consistent over this temperature range. The CTE value of the thermoset device reflects the isotropic nature of the compound.

Yet another illustrative embodiment and advantage of the present invention can be wherein the tensile strength of the epoxy composite generally may be greater than or equal to 35 MPa. For example, the tensile strength may be from 35 MPa to 250 MPa in one embodiment, from 50 MPa to 250 MPa in another embodiment, from 55 MPa to 125 MPa in still another embodiment, from 65 MPa to 125 MPa in even still another embodiment, and from 75 MPa to 100 MPa in even yet another embodiment, as measured by ASTM D-638, Type 1 tensile bar.

In another embodiment of the present invention, the fracture toughness of the epoxy composite can be measured in terms of critical-stress-intensity factor, K_{1c}, following the test method in ASTM D 5045-99. For example, the fracture toughness of the epoxy composite of the present invention may be generally a K_{1c} greater than 0.6 MPa-m^{0.5} in one embodiment; greater than 1.0 MPa-m^{0.5} in another embodiment; and greater than 1.5 MPa-m^{0.5} in one embodiment. In one illustrative embodiment, the fracture toughness of the epoxy composite of the present invention may be generally a K_{1c} may be greater than 0.6 MPa-m^{0.5} to 10 MPa-m^{0.5}; and from 1.0 MPa-m^{0.5} to 5 MPa-m^{0.5} in another embodiment.

Non-cracking or chipping of the epoxy composite provides an indication of both the machinability of the composite when the epoxy composite is drilled or tapped (including self-tapping screws), but also the ability of the material to produce high quality machined surfaces as illustrated by surface smoothness as well as thread strength when tapped holes are drilled in the composite. This can be measured for example by torque to failure when threaded screws are inserted and tightened to thread failure in the tapped holes. Such attributes, are another illustration of the advantages of the present invention.

It is advantageous to prepare the epoxy composite as a non-foamed structure that is light weight; and any one or more of the following properties including for example an improved thermal conductivity, an improved surface for plating, improved tensile strength and improved compressive strength over a foam structure.

The desired application in the present invention requires good surface properties for the plating step, as well as overall geometrical requirements, and any significant defect, such as large pores would compromise the usefulness of the material. It is known that polymer foaming either via gas injection, or in-situ gas generation, especially as it pertains to cell size control can be a delicate process. Therefore, eliminating a foaming step is desirable to obtain both good surface quality for metal plating and a simplified manufacturing process. In the case of syntactic foams, where lighter weight hollow particles such as glass microspheres are incorporated into an epoxy formulation, generally both the tensile and the flexural strengths show a decreasing trend with the introduction of the microspheres compared to unfilled resins as described for example in Update on Syntactic Foams; B. John a C.P. Reghunadhan Nair; p. 23-39; RAPRA Publishing.

In addition, the epoxy composite of the present invention is metal plated. The ability to metal plate a polymer composite is one of the key features useful for RF cavity filter applications in accordance with the present invention. "Metal plateability" herein is defined as the ability to deposit a metal layer such as copper, silver or gold on the polymer composite via various plating techniques and plating would result in acceptable adhesion of the metal layer to the polymer composite as measured by a peel force. The required total thickness of the metal layers will vary depending on the specific application, but will typically be in the range of from 0.25 micron to 50 microns in one embodiment; from micron to 20 microns in another embodiment; from 0.25 micron to 10 microns in still another embodiment; and from 0.25 micron to 2.5 microns in yet another embodiment. An adhesion strength in terms of peel force of the metal layer from the polymer composite in general may be greater than 1.0 pounds/inch (lb/in) (0.17 N/mm) in one embodiment, > 1.5 lb/in (0.26 N/mm) in still another embodiment, greater than or equal to 2.0 lb/in (0.35 N/mm) in yet another embodiment. As an illustration of another embodiment, the peel force may be from 1.0 lb/in (0.17 N/mm) to 10 lb/in (1.75 N/mm). The test method ASTM B-533 may be used as the standard test method for peel strength of metal electroplated plastic.

The above properties are advantageous to ensure (1) the dimensional stability of the filter unit made from the curable composition of the present invention when the unit is in operating conditions as measured, for example, by CTE; (2) the easiness and robustness to process the compositions; and (3) the overall thermo mechanical performance of the filter unit under operating conditions.

Once the curable composition of the present invention can be cured to form the cured epoxy resin composite, in one embodiment, the cured epoxy resin composite may optionally be further processed by, for example, machining and/or preparing the surface of the resulting cured composite.

In a process for metalizing the cured composite described above, a copper plating process may be carried out on the epoxy composite materials of the present invention from which a high quality metallization layer of copper can be achieved. A high quality metallization layer with reference to a plated composite substrate herein means the peeling force of the copper layer off the substrate is for example, higher than 2 lb/in (0.35 N/mm). The high quality metallization layer also means that the plating layer is stable in an outdoor use temperature range. One method to ensure the plating on the composite substrate is of high quality can be, for example, to heat the plated filter up to 160 °C for 30 minutes; thereafter the resulting heated item can be cooled rapidly in water. The resulting cooled item of high quality does not show any signs of blistering or loose metallic flakes that can be readily removed from the substrate. For example, an assessment of the removability of the plating from the substrate can be done (i) by manually using the hand to remove loose metallic flakes or (ii) by applying moderate force to the plated substrate with an object.

The metallization process may be carried out by initially processing a substrate part through an appropriate pretreatment process, followed by electroless plating a thin layer (for example, from 0.25 micron to 2.5 microns) of metal such a copper, or nickel. For example, in one embodiment, a layer of copper may be plated on the composite wherein the layer may be 1 micron in thickness. The electroless plating may then be followed by plating a metal such as copper to a thickness up to 20 micron in one embodiment; and thereafter another layer of metal such as silver may optionally be applied by plating to the desired thickness of the layer such as for example 1 micron. In another embodiment, multiple layers may be used or, in a preferred embodiment, a single plating layer may be used.

For example, additional metal layers may be conveniently applied over an initial metallization layer by using electrolytic plating techniques or other plating techniques such as electroless deposition or immersion deposition. Typically, electrolytic processes are used for the addition of thicker layers, as these processes are fast. In an embodiment where an additional copper layer is desired, the layer could also be added using an electroless process (although deposition rate for the greater thickness may be lower). For an embodiment where a final silver layer is desired, the thickness can be small; and therefore, either electroless or immersion deposition can also be used).

The appropriate pretreatment methods include, but are not limited to, chemical acid/base etching and physical roughening (for example, sandblasting) treatments.

For the epoxy composite material of the present invention, one preferred embodiment of the pretreatment method may be a chemical etching method, based on an initial conditioning step in an alkaline, solvent-containing solution, followed by treatment in a hot alkaline solution containing permanganate ion. Residues of the permanganate etch step are then removed in a neutralization bath, containing an acidic solution of a hydroxylamine compound.

In one embodiment, the curable epoxy resin formulation and composite of the present invention may be used to manufacture radio frequency filters. Radio frequency filters are incorporated, for example, into tower-top electronics, such as wireless filter applications. Radio frequency filters, their characteristics, their fabrication, their machining, and their overall production are described, for example, in U.S. Patent No. 7,847,658; and U.S. Patent No. 8,072,298.

For example, the radio frequency filter includes a housing body with other components known in the art to provide a functional radio frequency cavity filter. For instance, the body housing can further include a cover plate fastened to the body housing that encloses resonating cavities of the body housing. One skilled in the art would be familiar with other components that the body housing could have to facilitate the operation of the radio frequency filter.

In general, the process used to manufacture the radio frequency filter includes, for example, a process step of forming a radio frequency filter body housing from the curable thermoset epoxy resin composition of the present invention, wherein the curable thermoset epoxy resin composition comprises (i) at least one epoxy resin; (ii) at least one toughening agent comprising an amphiphilic polyether block copolymer, a core shell rubber, a carboxyl terminated butadiene acrylonitrile elastomer, or mixtures thereof; (iii) at least one hardener; and (iv) at least one filler; the filler material being uniformly distributed and randomly oriented throughout the epoxy resin polymer. The process further includes a step of coating the body housing with an electrically conductive material.

In one embodiment, the liquid curable epoxy resin composition can be placed in a cavity die or a mold and then cured by a casting process. The curable epoxy resin composition can then be polymerized after closing and heating the mold. One skilled in the art would be familiar with other casting or molding processes, such as transfer or reaction injection molding processes, which could be used. For example, the curable epoxy resin composition can be heated at an elevated temperature to melt the composition and then the composition may be transferred into a heated mold where the mixture reacts to form a thermoset product.

In another embodiment, forming the body housing may include a step of machining a block of the cured epoxy resin composite product into a target shape of the body housing. Machining is desirable when the polymeric composition can be formed in a shape that is not the same as the target shape of the body housing. When machining the cured epoxy resin composite product into its target shape, the cavity die can be block-shaped, or the curable epoxy resin composition can be extruded from the die as a block-shaped member. The block of cured epoxy resin composite product can be machined using known machining devices in the art. Other embodiments of forming the cured product are disclosed for example in U.S. Patent No. 7,847,658.

In one embodiment, the coating process of the body housing with an electrically conductive material may include depositing the body housing with successive layers of metal (for example, copper and silver). For instance, electroless or electrolytic plating processes, or, a combination of both, can be used to coat a portion of the surface of the body housing or the entire surface of the body housing with such electrically conductive materials.

In another embodiment, some of the components in the curable composition can be pre-coated with a metal to enhance the initiation of electroplating. For instance, at least some of the particles or fibers of the filler material mixed with the polymer can have a copper layer deposited via chemical vapor deposition. The skilled artisan would be familiar with other metal coating processes. Other conventional techniques such as spraying or painting could also be used to coat the body housing.

Other steps to complete the manufacture of the body housing can include attaching a plate onto the body housing, such that the cavities of the body housing are enclosed by the plate and the walls of the body housing. Attaching the plate can include screwing, nailing or bolting the plate to the body housing, or, adhesively bonding the plate to the body housing. The manufacture of the body housing can include attaching tuning rods to the body housing or plate, for example, by screwing, or, otherwise adjustably attaching the tuning rods, into the plate or the body housing.

One skilled in the art would be familiar with other steps in the manufacture of the radio frequency filter, and may depend on the particular configuration of the apparatus in which the radio frequency filter is used. For instance, when the apparatus is a wireless transmission system, the process of the present invention can include the step of attaching the radio frequency filter body housing to a mobile base station antenna mast.

### EXAMPLES

The following examples and comparative examples further illustrate the present invention in detail but are not to be construed to limit the scope thereof.

The terms and designations used in the Examples include, for example, the following wherein: D.E.N 425 is an epoxy resin having an EEW of 172, and is commercially available from The Dow Chemical Company; D.E.R. 332 is an epoxy resin having an EEW of 171 and is commercially available from The Dow Chemical Company; D.E.R. 542 is an epoxy resin having an EEW of 332 and is commercially available from The Dow Chemical Company; "NMA" stands for nadic methyl anhydride, and is commercially available from Polysciences; "ECA100" stands for Epoxy Curing Agent 100, is commercially available from Dixie Chemical, and ECA 100 generally comprises methyltetrahydrophthalic anhydride greater than 80 % and tetrahydrophthalic anhydride greater than 10 %; "1MI" stands for 1-methylimidazole, and is commercially available from Aldrich Chemical; SILBOND® W12EST is an epoxy silane treated quartz with d_{50%} grain size of 16 microns, and is commercially available from Quarzwerke; SILBOND® FW12EST is an epoxy silane treated quartz with d_{50%} grain size of 17 microns, and is commercially available from Quarzwerke; SILBOND® 126EST is an epoxy silane treated quartz with d_{50%} grain size of 22 microns, and is commercially available from Quarzwerke; HYMOD® SB432 SE is an aluminum trihydrate with proprietary surface treatment commercially available from J.M. Huber Corporation; KEMGARD® 911C is a zinc molybdate/magnesium silicate complex commercially available from J.M. Huber Corporation; EXOLIT AP 422 is an ammonium polyphosphate with average particle size of about 15 µm commercially available from Clariant. EXOLIT OP1230 is phosphinate with average particle size ranging between 20 and 40 µm commercially available from Clariant; BYK-A 525 is a solution of polyether modified methylalkyl polysiloxane copolymer as an air release additive and BYK-W 9010 is a wetting/dispersing additive are and both are commercially available from BYK Additives & Instruments, a member of ALTANA; FORTEGRA™ 100 Epoxy Toughener (F100) is a toughening agent, and commercially available from The Dow Chemical Company; FORTEGRA™ 201 Toughened Epoxy Resin (F201) is an elastomer-modified epoxy functional adduct formed by the reaction of a bisphenol A liquid epoxy resin and a carboxyl terminated butadiene-acrylonitrile elastomer with an elastomer content of 40 % by weight and is commercially available from The Dow Chemical Company; FORTEGRA™ 301 Toughened Epoxy Resin (F301) is a dispersion of preformed core shell rubber (CSR) particles in a bisphenol A liquid epoxy resin containing 15 wt % CSR and is commercially available from The Dow Chemical Company.

In the Examples, the following standard analytical equipment and methods are used:

### Glass Transition Temperature (T_{g}) Measurements

A portion of the cured epoxy formulation is placed in a differential scanning calorimeter (DSC) with heating and cooling at 10 °C/minute at a first heating scan of from 0 °C to 200 °C or 250 °C to a second heating scan of from 0 °C to 200 °C or 250 °C. Tg is reported as the half-height value of the 2^{nd} order transition on the second heating scan of from 0 °C to 200 °C or 250 °C.

### Tensile Strength Property Measurements

Tensile property measurements (tensile strength and % elongation at break) are made on the cured epoxy formulation according to ASTM D638 using a Type 1 tensile bar and strain rate of 0.2 inch/minute.

### Thermal Conductivity Measurements

Thermal conductivity measurements are made on the cured epoxy formulation according to ISO 22007-2 (the transient plane heat source [hot disc] method). Thermal conductivity of fillers are generally measured and reported in the art.

### CTE Measurements

The coefficient of thermal expansion (CTE) is measured using a Thermomechanical Analyzer (TMA 2940 from TA Instruments). An expansion profile is generated using a heating rate of 5 °C/minute, and the CTE is calculated as the slope of the expansion profile curve as follows: CTE = ΔL/(ΔT x L) where ΔL is the change in sample length (µm), L is the original length of the sample (m) and ΔT is the change in temperature (°C). The temperature range over which the slope is measured is 20 °C to 60 °C on the second heat. This particular temperature range was selected because it is the most common operation temperature from an overall range of -50°C to 100°C.

### Density/Specific Gravity Measurements

The density/specific gravity is measured using the method in distilled water (120 mL) containing Alconox® detergent (0.84 grams) where specific gravity of solution is 0.9975 in accordance with ASTM D792.

### Viscosity of Epoxy Formulation Measurements

Complex viscosity as function of temperature is obtained using an TA Instruments ARES G2 rheometer fitted with a parallel plate fixture. The plate diameter is 50 mm running in flow mode at shear rates of 10 1/second and at a temperature ramp of at 5 °C/minute starting at 40 °C.

### Flame Retardancy Test

Flame retardancy is tested in accordance with Underwriters Laboratories Inc. UL 94 standard for safety "Tests for Flammability of Plastic Materials for Parts in Devices and Appliances".

### Plating Thermal Shock Test

The epoxy samples are plated with a layer of electroless copper and a specimen is placed in an oven at 140°C for 30 minutes and then quickly removed and quenched in water. The specimens are observed for any peeling or delamination of the copper coating from the epoxy.

### Plating Long-term Thermal Cycling Test

The epoxy samples are plated with a layer of electroless copper and a specimen is placed in a humidity chamber cycling temperature from -30 °C to 85 °C at 85 % relative humidity for 35 days. After aging, the specimens are observed for any peeling or delamination of the copper coating from the epoxy.

### Example 1-18 and Comparative Examples A and B

Examples of the present invention epoxy composite compositions and comparative examples are shown in Tables I-III. The mixing, casting, and curing processes for the epoxy composite compositions are generally carried out as described below.

### General Procedure

The requisite amount of filler is dried overnight in a vacuum oven at a temperature of approximately (∼) 70 °C. The epoxy resin which typically contains FORTEGRA™ toughening agents and anhydride hardeners are separately pre-warmed to ∼ 60 °C. Into a wide mouth plastic container is loaded by weight the designated amount of warm epoxy resin, warm anhydride hardeners, optional BYK-A 525 and/or BYK W9010, and 1-methyl imidazole which are hand swirled before adding in the warm filler which may include FR additives. The container's contents are then mixed on a FlackTek SpeedMixer™ with multiple cycles of ∼ 1-2 minutes duration from about 800 to about 2000 rpm.

The mixed formulation is loaded into a temperature controlled ∼ 500 to 1000 mL resin kettle with overhead stirrer using glass stir-shaft and bearing with Teflon® blade along with a vacuum pump and vacuum controller for degassing. A typical degassing profile is performed between about 55 °C and about 75 °C with the following stages being representative: 5 minutes, 80 rpm, 100 Torr; 5 minutes, 80 rpm, 50 Torr; 5 minutes, 80 rpm, 20 Torr with N₂ break to ∼760 Torr; 5 minutes, 80 rpm, 20 Torr with N₂ break to ∼ 760 Torr; 3 minutes, 80 rpm, 20 Torr; 5 minutes, 120 rpm, 10 Torr; 5 minutes, 180 rpm, 10 Torr; 5 minutes, 80 rpm, 20 Torr; and 5 minutes, 80 rpm, 30 Torr. Depending on the size of the formulation to be degassed the times at higher vacuums can optionally be increased as well as the use of a higher vacuum of 5 Torr as desired.

Warm, degassed mixture is brought to atmospheric pressure and poured into the warm mold assembly described below. For the specific mold described below some amount between about 350 grams and 450 grams are typically poured into the open side of the mold. The filled mold is placed standing vertically in an 80 °C oven for about 16 hours with temperature subsequently raised and held at 140 °C for a total of 10 hours; then subsequently raised and held at final temperature ranging from about 175 °C to about 225 °C for a total of 4 hours; and then slowly cooled to ambient temperature (about 25 °C). (DER 542 and EXOLIT OP1230 containing formulations have a final cure temperature of approximately 200 °C; EXOLIT AP422 containing formulations have a final cure temperature of approximately 185 °C; HYMOD SB432E containing formulations have a final cure temperature of approximately 175 °C.)

### Mold Assembly

Onto two approximately 355 mm square metal plates with angled cuts on one edge is secured on each DUOFOIL™ (∼330 mm x 355 mm x approximately 0.38 mm). A U-spacer bar of approximately 3.05 mm thickness and silicone rubber tubing with approximately 3.175 mm ID x approximately 4.75 mm OD (used as gasket) are placed between the plates and the mold is held closed with C-clamps. Mold is pre-warmed in about 65 °C oven prior to its use. The same mold process can be adapted for castings with smaller metal plates as well as the use of thicker U-spacer bars with an appropriate adjustment in the silicone rubber tubing that functions as a gasket.

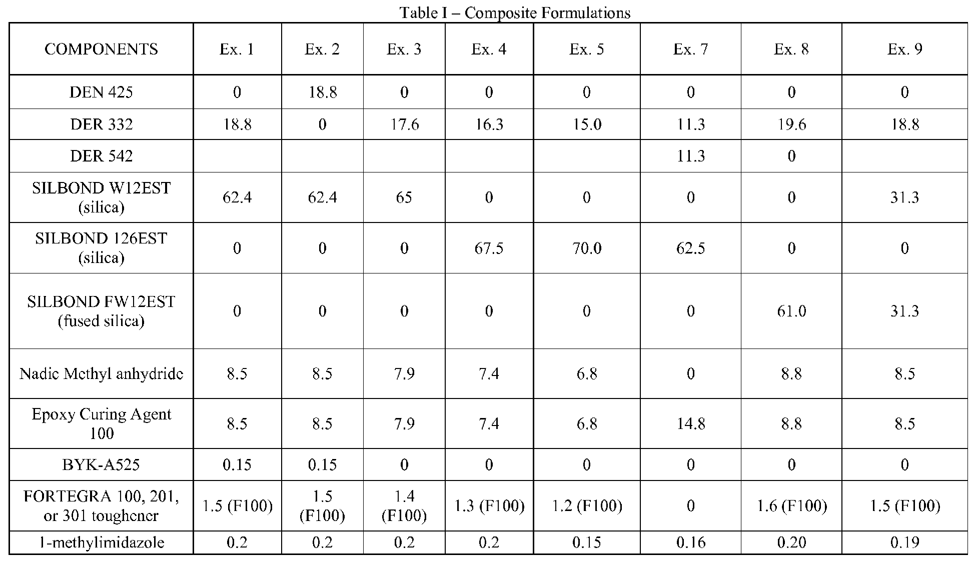

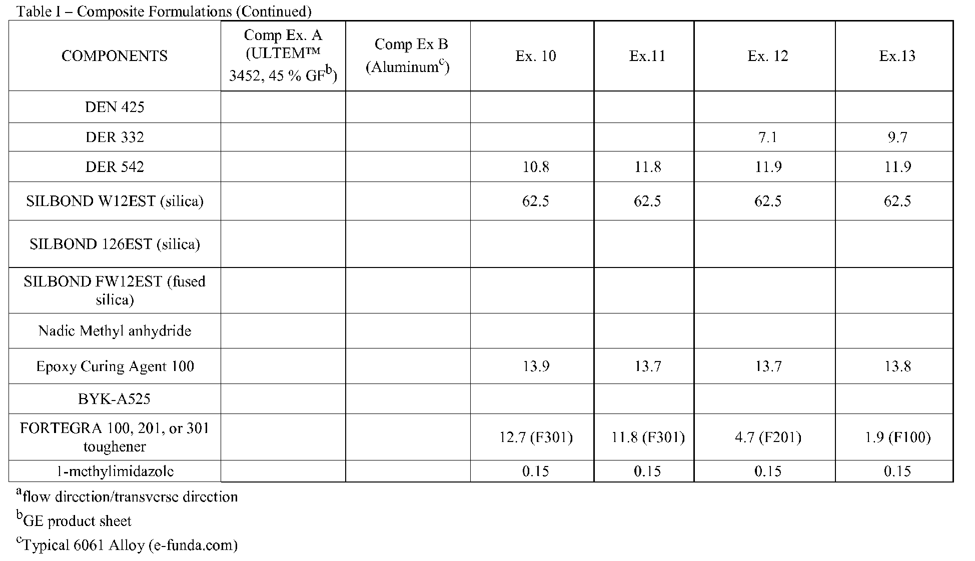

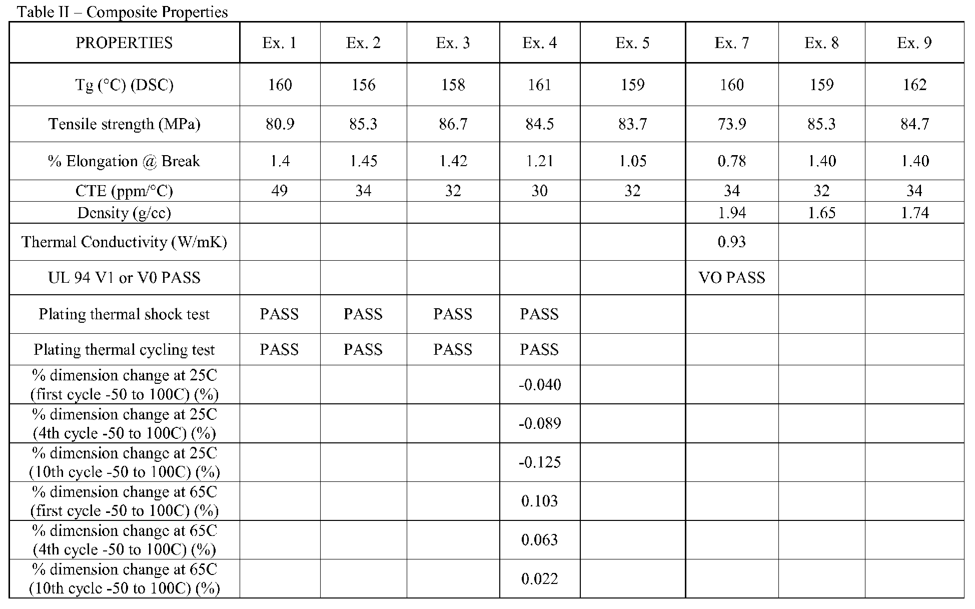

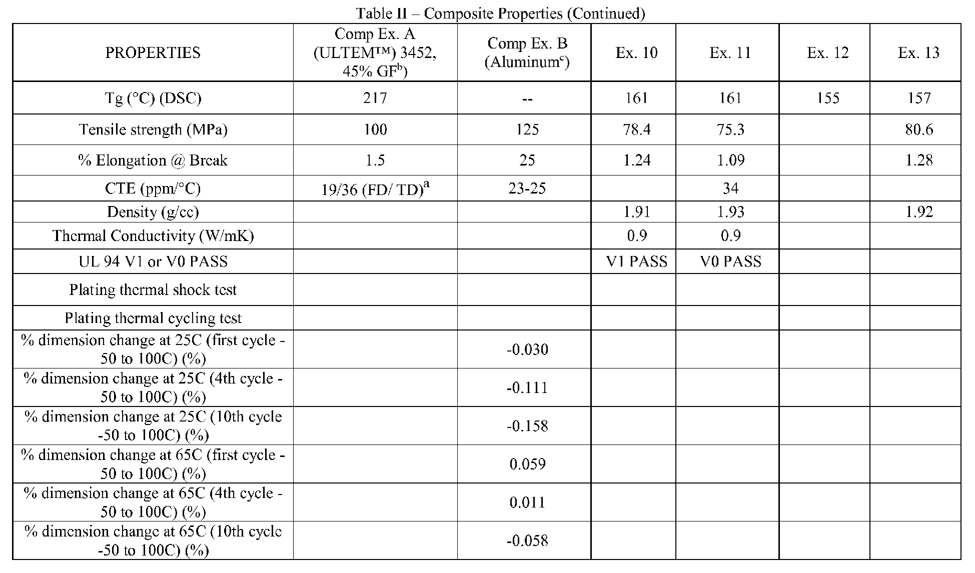

**Table III-Composite Formulations and Properties**

| COMPONENTS | Ex. 14 | Ex. 15 | Ex. 16 | Ex. 17 | Ex. 18 |
|---|---|---|---|---|---|
| DER 332 | 8.0 | 8.4 | 8.4 | 19.2 | 16.3 |
| DER 542 | | | | | |
| SILBOND W12EST (silica) | | | | 37.5 | 37.5 |
| SILBOND 126EST (silica) | 8.5 | 54.8 | 37.5 | | |
| HYMOD SB 432E | 45.0 | | | | |
| KEMGARD 911C | 9.0 | | | | |
| EXOLIT OP1230 | | 7.5 | | | |
| EXOLIT AP422 | | | 25.0 | 25.0 | 25.0 |
| Nadic Methyl anhydride | 8.2 | | | | |
| Epoxy Curing Agent 100 | 8.2 | 16.2 | 16.3 | 16.6 | 16.3 |
| BYK W9010 | 0.3 | 0.3 | | | |
| FORTEGRA 100, 201, or 301 toughener | 12.5 (F301) | 12.6 (F301) | 12.6 (F301) | 1.5 (F100) | 4.7 (F201) |
| 1 -methylimidazole | 0.17 | 0.18 | 0.18 | 0.18 | 0.18 |
| PROPERTIES | | | | | |
| Tg (°C) (DSC) | 156 | 146 | 148 | 146 | 143 |
| Tensile strength (MPa) | 54.5 | | 38.7 | 45.5 | |
| % Elongation @ Break | 0.88 | | 1.56 | 1.43 | |
| CTE (ppm/°C) | 39 | | 41 | | |
| Density (g/cc) | 1.77 | | 1.69 | 1.67 | |
| Thermal Conductivity (W/mK) | 0.9 | | 0.7 | | |
| UL 94 V1 or V0 PASS | VO PASS | V1 PASS | V0 PASS | | |
| Plating thermal shock test | | | | | |
| Plating thermal cycling test | | | | | |

### Example 19

In this Example 19, a formulation of the present invention (Formulation of Example 1) is cured to form an epoxy composite and then the epoxy composite is plated with a copper layer in accordance with a general plating procedure and as described in Table IV as follows:

### General Plating Procedure

The process used to plate epoxy resin composite substrate of the present invention may include a variety of techniques to render the surface receptive to application of metallization. Typically, epoxy substrates may be metalized by a process which first involves exposure, sequentially, to a composition containing materials, increasing the degree of attack in a subsequent etching step, then to an etching step and then to step which substantially removes residues from the etching step.

The first step often referred to as a "solvent swell", employs a "sweller" which may include materials such as solvents and / or alkaline materials such as alkali metal hydroxides. The second step, often referred to as the "desmear" step (from the common use of this process step to remove residual epoxy materials from copper surfaces, for example, during the manufacture of printed circuit boards), employs an "oxidizer" which may include strong oxidizing components capable of etching the epoxy, such as alkaline solutions of permanganate. The third step contains "neutralizer" materials capable of neutralizing residues of the oxidizing material, for example in the case of permanganate, compositions such as acidic solutions containing hydrogen peroxide, or hydroxylamine compounds. For epoxy materials that are particularly chemically resistant, these three steps may be repeated one or more times, to increase the degree of etching, so as to increase the adhesion of the subsequently applied metallizations.

In the examples of the present invention, an epoxy resin composite substrate is plated using a series of first, second and third steps as described above. Typically, the sweller, oxidizer, and neutralizer material is applied to the substrate at a certain temperature and for a predetermined period of time followed by a rinse step in between these three chemical application steps (for example, Steps 1-3). These series of three steps are carried out in sequence for any desired number of repetitions for example three times (Steps 1-9) as shown in Table IV.

After the etching steps, a catalytic material (most commonly, a colloidal palladium tin material) may be applied to the surface of the substrate. Prior to application of the catalytic material, the surface may be beneficially treated in a solution containing one or more additives promoting the subsequent adsorption of the colloidal material. In addition, immediately prior to the part being introduced to the catalyst solution, it is common practice to first immerse the part in a solution containing a similar mixture of components present in the colloid containing composition with the exception of the colloidal material itself, in order to increase the bath life of the colloid containing solution.

In the examples of the present invention after etching, the epoxy resin composite substrate is subjected to a conditioning step (Step 10), a microetching step (Step 11), and a predipping step (Step 12) prior to using a catalyst (Step 13), as described above. These treatment steps are carried out at a certain temperature and for a predetermined period of time followed by a rinse step in between these application steps (for example, Steps 10-13) as shown in Table IV.

After treatment in a catalyst composition, the substrate or part may be either treated with a so-called accelerating composition or, as shown in Table IV, directly introduced into an electroless metallization bath (Step 14) designed to operate without any intermediate step between catalyst bath and electroless metallization. A number of different electroless metallization compositions may be used to apply an adherent initial metallization layer that is sufficiently thick and durable to allow the subsequent application of a thicker layer of metal, either by electroless or, as shown in Table IV, by electrolytic deposition (Step 14) (due to the higher rate typically attainable by electrolytic processes).

After electroless metallization (Step 14), the part may be dried (Step 15) and then the part may be baked (Step 16) so as to improve the adhesion of the metallization. The baking step may be carried out at temperatures in the range of 80 °C to 150 °C for times of from 0 minutes to 200 minutes. The benefits of the baking step may depend on the specific composition of the material to be metalized.

After an acid dip step (Step 17) and an electroplating step (Step 18) according to the process sequence described in Table IV, the plated deposit, which is uniform and shows excellent smoothness and adhesion to the substrate, is tested for adhesion strength, for example by using the general procedure described in ASTM B-533, except that a test sample width of 1 cm is used. The measured forces for the 1 cm test width may then be converted to units of pounds/inch (lb/in) using the appropriate numerical conversion factor. The measured forces values are found to be between about 2.0 lb/in and about 2.4 lb/in.

In the Examples of the present invention, the resulting plated composite has a smooth and level surface of a plated copper layer and may contain an additional plated silver layer. Peel force measurements on the copper plated epoxy composite were conducted according to ASTM B-533 except that a test sample width of 1 cm is used.

**Table IV-Plating Procedure on Epoxy Composites**

| Step | Product | Chemicals (vol %) | Temperature (° C). | Time (min) | Time of Post Rinse (min) |
|---|---|---|---|---|---|
| 1 | Sweller | 11.5% CUPOSIT™ Z Solution +12.5% CIRCUPOSIT™ MLB Conditioner 211 | 75 | 5 | 3 |
| 2 | Oxidizer | 15% CUPOSIT Z Solution + 10% CIRCUPOSIT MLB Promoter 213A-1 | 80 | 10 | 3 |
| 3 | Neutralizer | 5% CIRCUPOSIT MLB Neutralizer 216-5 | 40 | 5 | 3 |
| 4 | Sweller | 11.5% CUPOSIT™ Z Solution +12.5% CIRCUPOSIT™ MLB Conditioner 211 | 75 | 5 | 3 |
| 5 | Oxidizer | 15% CUPOSIT Z Solution + 10% CIRCUPOSIT MLB Promoter 213A-1 | 80 | 10 | 3 |
| 6 | Neutralizer | 5% CIRCUPOSIT MLB Neutralizer 216-5 | 40 | 5 | 3 |
| 7 | Sweller | 11.5% CUPOSIT™ Z Solution +12.5% CIRCUPOSIT™ MLB Conditioner 211 | 75 | 5 | 3 |
| 8 | Oxidizer | 15% CUPOSIT Z Solution + 10% CIRCUPOSIT MLB Promoter 213A-1 | 80 | 10 | 3 |
| 9 | Neutralizer | 5% CIRCUPOSIT MLB Neutralizer 216-5 | 40 | 5 | 3 |
| 10 | Conditioner | 3% CIRCUPOSIT Conditioner 3323A | 40 | 5 | 4 |
| 11 | Micro etch | 2% H₂SO₄ + 100 g/l Sodium persulfate | 22 | 1 | 3 |
| 12 | Predip | 250 g/l CATAPREP™ 404 Pre-Dip | 22 | 1 | ----- |
| 13 | Catalyst | 250 g/l CATAPREP™ 404 Pre-Dip + 2% CATAPOSIT™44 Catalyst Concentrate | 40 | 5 | 2 |
| 14 | Electroless Copper | CIRCUPOSIT 3350-1 Electroless Copper 15% 3350 M-1 + 1% 3350 A-1 with 8 g/l NaOH, 3 g/l formaldehyde | 43 | 15 | 2 |
| 15 | Dry part | Forced air | 25 | 1 | |
| 16 | Bake | Bake electrolessly metallized sample | 120 | 60 | |
| 17 | Acid Dip | 10 % sulfuric acid. | 25 | 1 | 1 |
| 18 | Electrolytic Copper | Acid copper electroplating bath (at current density of 12 amps/square ft) at 25 °C for 90 minutes to obtain a 25 micron deposit thickness. | 25 | 90 | 2 |

### Example 20 and Comparative Example C

### RF Filter Prototype Fabrication and Testing Procedures

Two prototype RF Filter boxes (Example 20 and Comparative Example C) were prepared as follows:
The composition of Example 1 was molded into a block and subsequently machined into an open rectangular box of approximate size 58 mm long x 35 mm wide x 29 mm deep with a wall thickness of approximately 2 mm (this Example 20 of the present invention). A cover plate was also molded out of the composition of Example 1 in such a shape as to fit as a lid on the box and be tightly closed with screws. The box and cover plate were plated with an electroless copper coating under a silver coating so as to create an electrically conductive surface.

An Al or Al alloy box and cover plate of similar size was also plated as a comparative example (Comparative Example C). Both plated boxes (Example 19 and Comparative Example C) were fabricated into similar RF filter devices containing a single resonator and two connectors.

Testing of the above two prototypes, Example 20 and Comparative Example C, was conducted utilizing a vector network analyzer and temperature chamber, and the results of the testing is described in Table V. The present invention prototype (Example 20) exhibited an advantage over the comparative prototype (Comparative Example C) in terms of insertion loss and Q-loaded at room temperature (about 25 °C). The prototypes were also heated to 65 °C, and the present invention prototype (Example 20) exhibited less frequency drift than the comparative prototype (Comparative Example C) as determined by visual observation.

**TABLE V-Results of Epoxy Composite Prototype Testing**

| | Prototype Example 20 | Prototype Comparative Example C |
|---|---|---|
| Insertion Loss (dB) | 0.44 | 0.67 |
| Q-loaded | 31.8 | 25.9 |
| Initial center frequency (MHz) | 1577.8 | 1550.3 |
| Center frequency at 60°C (MHz) | 1576.7 | 1547.8 |
| Total drift (MHz) | 1.1 | 2.5 |
| Total drift (%) | 0.07 | 0.16 |

## Claims

1. A process for preparing a non-foamed cured composite material for use in a telecommunication device comprising the steps of:
(a) providing a curable thermoset epoxy resin composition comprising
(i) at least one epoxy resin;
(ii) at least one toughening agent comprising an amphiphilic polyether block copolymer, a core shell rubber, a carboxyl terminated butadiene acrylonitrile elastomer, or mixtures thereof;
(iii) at least one hardener; and
(iv) at least one filler;
(b) curing the curable thermoset epoxy resin composition of step (a) to form a cured composite; wherein the curable thermoset epoxy resin composition upon curing provides a cured composite product having a density of less than 2.7 g/cc as measured by ASTM D-792; and
(c) coating at least a portion of the surface of the cured composite of step (b) with an electrically conductive metal layer to form a metalized coating on at least a portion of the surface of the cured composite.

2. The process of claim 1, wherein the toughening agent comprises an amphiphilic polyether block copolymer containing at least one epoxy resin miscible block segment and at least one epoxy resin immiscible block segment; wherein the miscible block segment comprises at least one polyether structure; and wherein the immiscible block segment comprises at least one polyether structure.

3. The process of claim 1, wherein the curable thermoset epoxy resin composition includes a flame retardant reactant compound or a flame retardant additive.

4. The process of claim 1, wherein the curable thermoset epoxy resin composition has a complex viscosity at 80 °C of less than 200,000 mPa-s.

5. The process of claim 1, wherein the curable thermoset epoxy resin composition upon curing provides a cured product with a balance of properties comprising a glass transition temperature of from 100 °C to 300 °C; a coefficient of thermal expansion of from 0 ppm/°C to 80 ppm/°C at a temperature of from -50 °C to 85 °C; a tensile strength of from 35 MPa to 250 MPa a thermal conductivity from 0.2 W/m-K to 300 W/m-K; and a density of from 1.2 g/cm³ to 2.7 g/cm³ as measured by ASTM D-792.

6. The process of claim 1, wherein the curable thermoset epoxy resin composition includes a filler; and wherein the filler comprises a thermally conducting filler.

7. The process of claim 1, wherein the curable thermoset epoxy resin composition includes a filler; and wherein the filler comprises an epoxy-silane treated quartz.

8. A cured product made by the process of claim 1.

9. The product of claim 8, wherein the cured product exhibits a balance of properties comprising a glass transition temperature of from 100 °C to 300 °C; a coefficient of thermal expansion of from 0 ppm/°C to 80 ppm/°C at a temperature of from -50 °C to 85 °C; a tensile strength of from 35 MPa to 250 MPa; a thermal conductivity from 0.2 W/m-K to 300 W/m-K; and a density of from 1.2 g/cm³ to 2.7 g/cm³ as measured by ASTM D-792.

10. The product of claim 8, wherein the cured product includes a metal coating on at least a portion of the surface of the cured product.

11. The product of claim 8, wherein the cured product comprises a metalized composite material.

12. The product of claim 8, comprising a radio frequency cavity filter, a heat sink, or an enclosure for electronic components.

13. The product of claim 8, comprising a heat sink.

14. The product of claim 8, comprising an enclosure for electronic components.

## Patentansprüche

1. Ein Verfahren zum Herstellen eines nicht geschäumten gehärteten Verbundstoffmaterials zur Verwendung in einer Telekommunikationsvorrichtung, das die folgenden Schritte beinhaltet:
(a) Bereitstellen einer härtbaren duroplastischen Epoxidharzzusammensetzung, die Folgendes beinhaltet:
(i) mindestens ein Epoxidharz;
(ii) mindestens einen Schlagzähigkeitsverbesserer, beinhaltend ein amphiphiles Polyetherblockcopolymer, einen Kern-Schale-Kautschuk, ein carboxylterminiertes Butadien-Acrylnitril-Elastomer oder Mischungen davon;
(iii) mindestens ein Härtungsmittel; und
(iv) mindestens einen Füllstoff;
(b) Härten der härtbaren duroplastischen Epoxidharzzusammensetzung von Schritt (a), um einen gehärteten Verbundstoff zu bilden; wobei die härtbare duroplastische Epoxidharzzusammensetzung nach dem Härten ein gehärtetes Verbundstoffprodukt mit einer Dichte von weniger als 2,7 g/cm³, wie nach ASTM D-792 gemessen, bereitstellt; und
(c) Beschichten mindestens eines Teils der Oberfläche des gehärteten Verbundstoffs von Schritt (b) mit einer elektrisch leitenden Metallschicht, um auf mindestens einem Teil der Oberfläche des gehärteten Verbundstoffs eine metallisierte Beschichtung zu bilden.

2. Verfahren gemäß Anspruch 1, wobei der Schlagzähigkeitsverbesserer ein amphiphiles Polyetherblockcopolymer beinhaltet, das mindestens ein mit Epoxidharz mischbares Blocksegment und mindestens ein mit Epoxidharz unmischbares Blocksegment enthält; wobei das mischbare Blocksegment mindestens eine Polyetherstruktur beinhaltet; und wobei das unmischbare Blocksegment mindestens eine Polyetherstruktur beinhaltet.

3. Verfahren gemäß Anspruch 1, wobei die härtbare duroplastische Epoxidharzzusammensetzung eine flammhemmende Reaktantenverbindung oder einen flammhemmenden Zusatzstoff umfasst.

4. Verfahren gemäß Anspruch 1, wobei die härtbare duroplastische Epoxidharzzusammensetzung eine komplexe Viskosität bei 80 °C von weniger als 200 000 mPa-s aufweist.

5. Verfahren gemäß Anspruch 1, wobei die härtbare duroplastische Epoxidharzzusammensetzung nach dem Härten ein gehärtetes Produkt mit einer Ausgewogenheit an Eigenschaften bereitstellt, beinhaltend eine Glasübergangstemperatur von 100 °C bis 300 °C; einen Wärmeausdehnungskoeffizienten von 0 ppm/°C bis 80 ppm/°C bei einer Temperatur von -50 °C bis 85 °C; eine Zugfestigkeit von 35 MPa bis 250 MPa; eine Wärmeleitfähigkeit von 0,2 W/m-K bis 300 W/m-K; und eine Dichte von 1,2 g/cm³ bis 2,7 g/cm³, wie nach ASTM D-792 gemessen.

6. Verfahren gemäß Anspruch 1, wobei die härtbare duroplastische Epoxidharzzusammensetzung einen Füllstoff umfasst; und wobei der Füllstoff einen wärmeleitenden Füllstoff beinhaltet.

7. Verfahren gemäß Anspruch 1, wobei die härtbare duroplastische Epoxidharzzusammensetzung einen Füllstoff umfasst; und wobei der Füllstoff einen mit Epoxysilan behandelten Quarz beinhaltet.

8. Ein gehärtetes Produkt, das durch das Verfahren gemäß Anspruch 1 gefertigt ist.

9. Produkt gemäß Anspruch 8, wobei das gehärtete Produkt eine Ausgewogenheit an Eigenschaften zeigt, beinhaltend eine Glasübergangstemperatur von 100 °C bis 300 °C; einen Wärmeausdehnungskoeffizienten von 0 ppm/°C bis 80 ppm/°C bei einer Temperatur von -50 °C bis 85 °C; eine Zugfestigkeit von 35 MPa bis 250 MPa; eine Wärmeleitfähigkeit von 0,2 W/m-K bis 300 W/m-K; und eine Dichte von 1,2 g/cm³ bis 2,7 g/cm³, wie nach ASTM D-792 gemessen.

10. Produkt gemäß Anspruch 8, wobei das gehärtete Produkt auf mindestens einem Teil der Oberfläche des gehärteten Produkts eine Metallbeschichtung umfasst.

11. Produkt gemäß Anspruch 8, wobei das gehärtete Produkt ein metallisiertes Verbundstoffmaterial beinhaltet.

12. Produkt gemäß Anspruch 8, beinhaltend einen Hochfrequenz-Hohlraumfilter, einen Kühlkörper oder ein Gehäuse für elektronische Komponenten.

13. Produkt gemäß Anspruch 8, beinhaltend einen Kühlkörper.

14. Produkt gemäß Anspruch 8, beinhaltend ein Gehäuse für elektronische Komponenten.

## Revendications

1. Un procédé pour la préparation d'un matériau composite durci non expansé pour une utilisation dans un dispositif de télécommunication comprenant les étapes de :
(a) fourniture d'une composition de résine époxy thermorigide durcissable comprenant
(i) au moins une résine époxy ;
(ii) au moins un agent de renforcement comprenant un copolymère séquencé de polyéther amphiphile, un caoutchouc à coeur-enveloppe, un élastomère de butadiène-acrylonitrile à terminaison carboxyle, ou des mélanges de ceux-ci ;
(iii) au moins un agent de réticulation ; et
(iv) au moins une charge ;
(b) durcissement de la composition de résine époxy thermorigide durcissable de l'étape (a) afin de former un composite durci ; dans lequel la composition de résine époxy thermorigide durcissable lors du durcissement fournit un produit composite durci ayant une masse volumique de moins de 2,7 g/cm³ telle que mesurée par l'ASTM D-792 ; et
(c) revêtement d'au moins une portion de la surface du composite durci de l'étape (b) avec une couche métallique électroconductrice afin de former un revêtement métallisé sur au moins une portion de la surface du composite durci.

2. Le procédé de la revendication 1, dans lequel l'agent de renforcement comprend un copolymère séquencé de polyéther amphiphile contenant au moins un segment de séquence miscible avec la résine époxy et au moins un segment de séquence non miscible avec la résine époxy ; dans lequel le segment de séquence miscible comprend au moins une structure de polyéther ; et dans lequel le segment de séquence non miscible comprend au moins une structure de polyéther.

3. Le procédé de la revendication 1, dans lequel la composition de résine époxy thermorigide durcissable inclut un composé réactif ignifuge ou un additif ignifuge.

4. Le procédé de la revendication 1, dans lequel la composition de résine époxy thermorigide durcissable a une viscosité complexe à 80 °C de moins de 200 000 mPa-s.

5. Le procédé de la revendication 1, dans lequel la composition de résine époxy thermorigide durcissable lors du durcissement fournit un produit durci avec un équilibre de propriétés comprenant une température de transition vitreuse allant de 100 °C à 300 °C ; un coefficient de dilatation thermique allant de 0 ppm/°C à 80 ppm/°C à une température allant de -50 °C à 85 °C ; une résistance à la traction allant de 35 MPa à 250 MPa ; une conductivité thermique de 0,2 W/m-K à 300 W/m-K ; et une masse volumique allant de 1,2 g/cm³ à 2,7 g/cm³ telle que mesurée par l'ASTM D-792.

6. Le procédé de la revendication 1, dans lequel la composition de résine époxy thermorigide durcissable inclut une charge ; et dans lequel la charge comprend une charge thermiquement conductrice.

7. Le procédé de la revendication 1, dans lequel la composition de résine époxy thermorigide durcissable inclut une charge ; et dans lequel la charge comprend un quartz traité par un époxy silane.

8. Un produit durci fabriqué par le procédé de la revendication 1.

9. Le produit de la revendication 8, le produit durci présentant un équilibre de propriétés comprenant une température de transition vitreuse allant de 100 °C à 300 °C ; un coefficient de dilatation thermique allant de 0 ppm/°C à 80 ppm/°C à une température allant de -50 °C à 85 °C ; une résistance à la traction allant de 35 MPa à 250 MPa ; une conductivité thermique de 0,2 W/m-K à 300 W/m-K ; et une masse volumique allant de 1,2 g/cm³ à 2,7 g/cm³ telle que mesurée par l'ASTM D-792.

10. Le produit de la revendication 8, le produit durci incluant un revêtement métallique sur au moins une portion de la surface du produit durci.

11. Le produit de la revendication 8, le produit durci comprenant un matériau composite métallisé.

12. Le produit de la revendication 8, comprenant un filtre à cavité radiofréquence, un dissipateur de chaleur, ou un boîtier pour composants électroniques.

13. Le produit de la revendication 8, comprenant un dissipateur de chaleur.

14. Le produit de la revendication 8, comprenant un boîtier pour composants électroniques.
